# EUROPEAN PATENT APPLICATION

(11) **EP 4 375 796 A1**
(43) Date of publication of application: **29.05.2024**
(21) Application number: 23765137.7
(22) Date of filing: 07.09.2023
(51) Int. Cl.: G06F 1/16, H04M 1/02

(54) **TRAY DETACHABLY COUPLED TO HOUSING, AND ELECTRONIC DEVICE COMRPISING SAME**

(30) Priority: 05.10.2022 KR 20220126980; 28.10.2022 KR 20220141911; 06.09.2023 KR 20230118471
(71) Applicant: Samsung Electronics Co., Ltd., Suwon-si, Gyeonggi-do 16677 (KR)
(72) Inventor: LEE, Yongseok, Suwon-si, Gyeonggi-do 16677 (KR); YOON, Byounguk, Suwon-si, Gyeonggi-do 16677 (KR)
(74) Representative: HGF
(86) International application number: PCT/KR2023/013466
(87) International publication number: WO 2024/076013

(57) **Abstract**

According to an embodiment, an electronic device includes a housing including a through-hole, a printed circuit board, and an tray moving outside of the through-hole by moving along a first direction or at least partially disposed on the printed circuit board by moving along a second direction to be inserted into the through-hole, wherein the tray includes a first accommodating hole and an insertion hole for insertion of an external member penetrating the outer surface of the tray, and an elastic member deformable by the external member, wherein the tray is movable to the outside of the through-hole, by a movement of the external member in contact with the elastic member in the first direction by being inserted into the insertion hole.

## Description

### [Technical Field]

The present disclosure relates to a tray detachably coupled to a housing and electronic device including same.

### [Background Art]

The electronic device may accommodate an interface chip for providing information to the electronic device. The electronic device may include a tray that may be coupled to the interface chip. The tray accommodating the interface chip may be detachably coupled to the electronic device.

### [Disclosure]

### [Technical Solution]

An electronic device is provided. According to an embodiment, the electronic device may include a housing including an opening. According to an embodiment, the electronic device may include a tray configured to be inserted into the housing through the opening. According to an embodiment, the tray may include a first hole exposed to the outside of the housing. According to an embodiment, the tray may include an elastic member including a second hole aligned with the first hole, and disposed in the housing while the tray is inserted into the housing. According to an embodiment, the elastic member may be configured to at least partially hold an external member inserted into the second hole through the first hole so as to at least partially eject the tray from the inside of the housing to the outside of the housing according to the external member being moved.

According to an embodiment, an electronic device may include a housing including a through-hole. According to an embodiment, the electronic device may include a printed circuit board disposed in the housing. According to an embodiment, the electronic device may include a tray in which at least a part is disposed on the printed circuit board by moving in a second direction to be inserted into the through-hole or that moves outside of the through-hole by moving in a first direction. According to an embodiment, the tray may include a first accommodating hole for inserting of an external member penetrating an outer surface of the tray exposed to outside of the housing and having a first cross-sectional area. According to an embodiment, the tray may include an elastic member deformable by the external member and including an insertion hole having a second cross-sectional area smaller than the first cross-sectional area. According to an embodiment, the tray may be movable to the outside of the housing by a movement of the external member in contact with the elastic member in the first direction by being inserted into the insertion hole.

According to an embodiment, an electronic device may comprise a housing including a through-hole. According to an embodiment, the electronic device may comprise a printed circuit board disposed in the housing. According to an embodiment, the electronic device may comprise a tray moving outside of the through-hole by moving along a first direction or at least partially disposed on the printed circuit board by moving along a second direction to be inserted into the through-hole. According to an embodiment, the tray may include an outer surface exposed to outside of the housing, in a state that the tray is inserted into the through-hole. According to an embodiment, the tray may include a first supporting surface facing the second direction within the tray. According to an embodiment, the tray may include a first accommodating hole for insertion of an external member extending from the outer surface to the first supporting surface, and having a first cross-sectional area. According to an embodiment, the tray may include a deformable elastic member including an insertion hole having a second cross-sectional area smaller than the first cross-sectional area, and at least part of one end of the elastic member is supported by the first supporting surface. According to an embodiment, the tray may include a second supporting surface facing the first supporting surface within the tray and supporting at least part of the other end of the elastic member opposite to the one end of the elastic member. According to an embodiment, the tray may be movable to the outside of the through-hole by a movement of the external member in contact with the elastic member in the first direction by being inserted into the insertion hole.

### [Description of the Drawings]

FIG. 1 is a block diagram of an electronic device in a network environment according to various embodiments.
FIG. 2 is a diagram illustrating an exemplary electronic device according to an embodiment.
FIG. 3 is an exploded perspective view of an exemplary electronic device according to an embodiment.
FIG. 4A is a perspective view of an exemplary electronic device according to an embodiment.
FIG. 4B is an exploded perspective view of an exemplary electronic device according to an embodiment.
FIG. 5A is a top plan view of an exemplary tray according to an embodiment.
FIG. 5B is an enlarged perspective view enlarging a part of an exemplary tray according to an embodiment.
FIG. 5C is a cross-sectional view illustrating an example in which an exemplary tray is cut along A-A' of FIG. 5B, according to an embodiment.
FIG. 6 is a cross-sectional view illustrating an example in which an exemplary tray is cut along B-B' of FIG. 5B, according to an embodiment.
FIG 7 is a cross-sectional view illustrating an example in which an exemplary tray is cut, according to an embodiment.
FIG 8 is a cross-sectional view illustrating an example in which an exemplary tray is cut, according to an embodiment.
FIG. 9A is an exploded perspective view of an exemplary tray according to an embodiment.
FIG. 9B is a cross-sectional view illustrating an example in which an exemplary tray is cut along C-C' of FIG. 9A, according to an embodiment.
FIG. 10 is a cross-sectional view of an exemplary tray according to an embodiment.
FIG. 11 is a cross-sectional view of an exemplary tray and an exemplary interface socket according to an embodiment.

### [Mode for Invention]

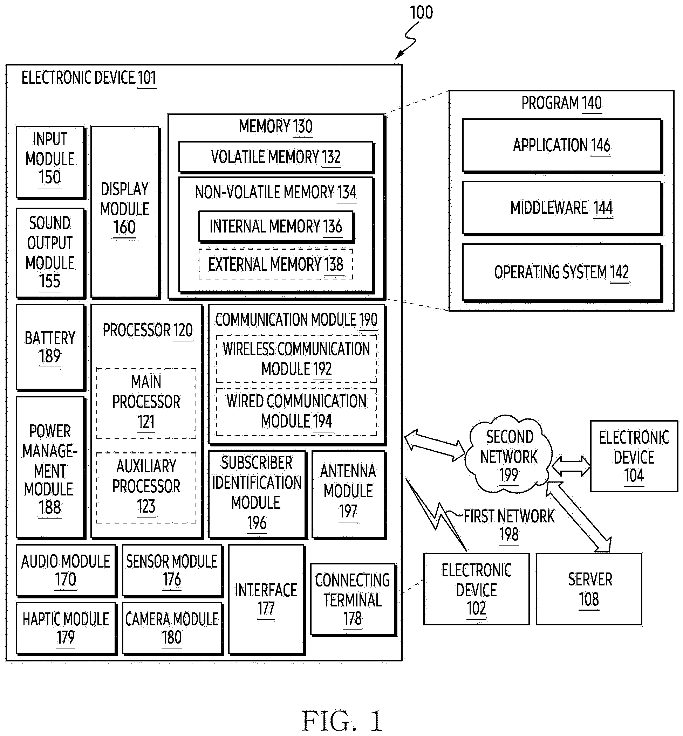

FIG. 1 is a block diagram illustrating an electronic device 101 in a network environment 100 according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

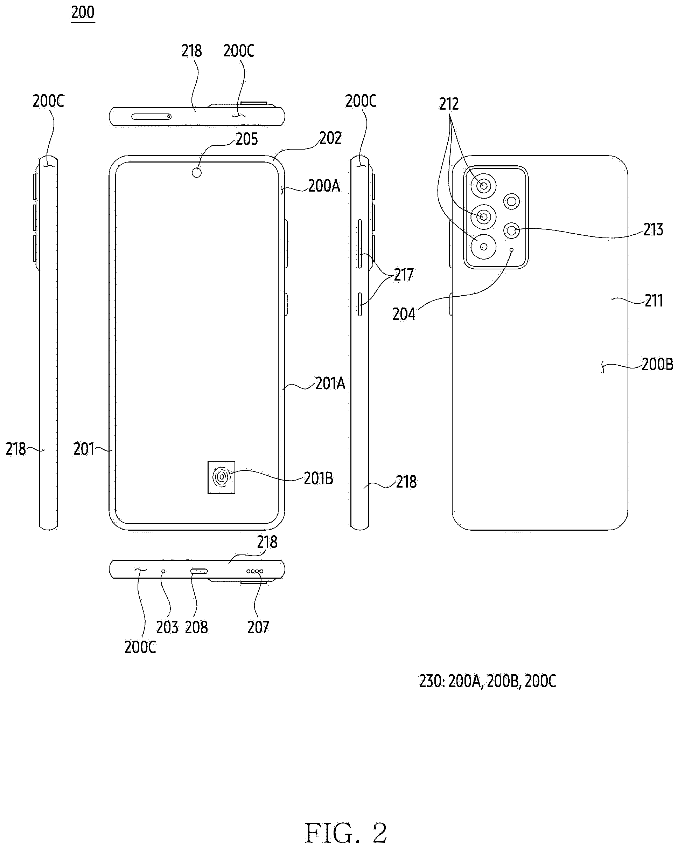

FIG. 2 is a diagram illustrating an electronic device according to an embodiment.

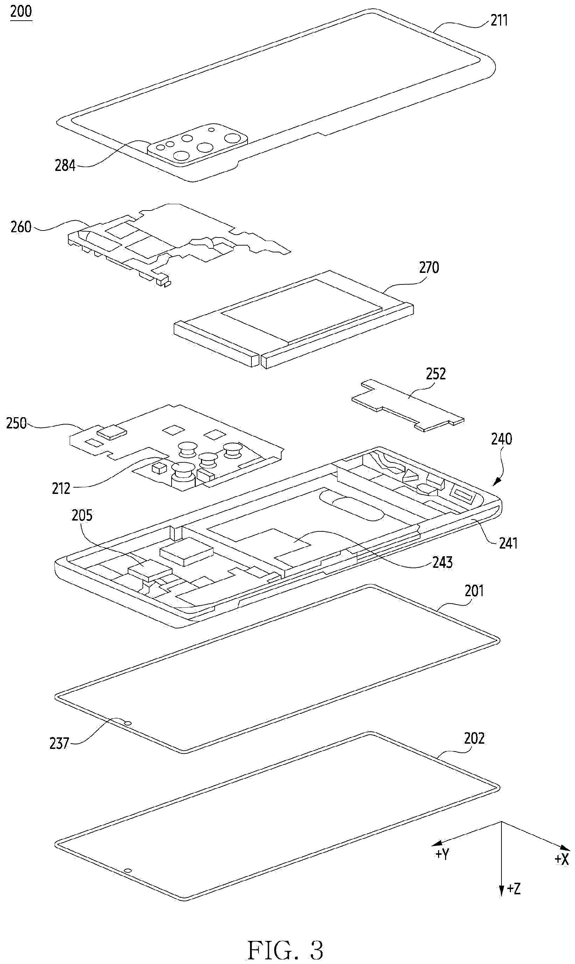

Referring to FIG. 2, an electronic device 200 (e.g., an electronic device 101 of FIG. 1) according to an embodiment may include a housing 210 forming an exterior of the electronic device 200. For example, the housing 210 may include a front surface 200A, a rear surface 200B, and a side surface 200C surrounding a space between the first surface 200A and the second surface 200B. In an embodiment, the housing 210 may refer to a structure (e.g., a frame structure 240 of FIG. 3) forming at least a portion of the first surface 200A, the second surface 200B, and/or the third surface 200C.

The electronic device 200 according to an embodiment may include a substantially transparent front plate 202. In an embodiment, the front plate 202 may form at least a portion of the first surface 200A. In an embodiment, the front plate 202 may include, for example, a glass plate including various coating layers or a polymer plate, but is not limited thereto.

The electronic device 200 according to an embodiment may include a substantially opaque rear plate 211. In an embodiment, the rear plate 211 may form at least a portion of the second surface 200B. In an embodiment, the rear plate 211 may be formed of coated or colored glass, ceramic, polymer, metal (e.g., aluminum, stainless steel (STS), or magnesium), or a combination of at least two of the above materials.

The electronic device 200 according to an embodiment may include a side bezel structure (or side member) 218 (e.g., a side wall 241 of a frame structure 240 of FIG. 3). In an embodiment, the side bezel structure 218 may be coupled to the front plate 202 and/or the rear plate 211 to form at least a portion of the third surface 200C of the electronic device 200. For example, the side bezel structure 218 may form all of the third surface 200C of the electronic device 200, and for example, the side bezel structure 218 may form the third surface 200C of the electronic device 200 together with the front plate 202 and/or the rear plate 211.

Unlike the illustrated embodiment, when the third surface 200C of the electronic device 200 is partially formed by the front plate 202 and/or the rear plate 211, the front plate 202 and/or the rear plate 211 may include a region that is bent from a periphery thereof toward the rear plate 211 and/or the front plate 202 and seamlessly extends. The extended region of the front plate 202 and/or the rear plate 211 may be positioned at both ends of, for example, a long edge of the electronic device 200, but is not limited to the above-described examples.

In an embodiment, the side bezel structure 218 may include a metal and/or a polymer. In an embodiment, the rear plate 211 and the side bezel structure 218 may be integrally formed and may include the same material (e.g., a metal material such as aluminum), but are not limited thereto. For example, the rear plate 211 and the side bezel structure 218 may be formed in separate configurations and/or may include different materials.

In an embodiment, the electronic device 200 may include at least one of a display 220, an audio module 203, 204, 207, a sensor module (not illustrated), a camera module 205, 212, 213, a key input device 217, a light emitting device (not illustrated), and/or a connector hole 208. In an embodiment, the electronic device 200 may omit at least one of the components (e.g., a key input device 217 or a light emitting device (not illustrated)), or may further include another component.

In an embodiment, the display 220 (e.g., a display module 160 of FIG. 1) may be visually exposed through a substantial portion of the front plate 202. For example, at least a portion of the display 220 may be visible through the front plate 202 forming the first surface 200A. In an embodiment, the display 220 may be disposed on the rear surface of the front plate 202.

In an embodiment, the appearance of the display 220 may be formed substantially the same as the appearance of the front plate 202 adjacent to the display 220. In an embodiment, in order to expand the area in which the display 220 is visually exposed, the distance between the outside of the display 220 and the outside of the front plate 202 may be formed to be generally the same.

In an embodiment, the display 220 (or the first surface 200A of the electronic device 200) may include a screen display area 220A. In an embodiment, the display 220 may provide visual information to a user through the screen display area 220A. In the illustrated embodiment, when the first surface 200A is viewed from the front, it is illustrated that the screen display area 220A is spaced apart from the outside of the first surface 200A and is positioned inside the first surface 200A, but it is not limited thereto. In an embodiment, when the first surface 200A is viewed from the front, at least a portion of the periphery of the screen display area 220A may substantially coincide with the periphery of the first surface 200A (or the front plate 202).

In an embodiment, the screen display area 220A may include a sensing area 220B configured to obtain biometric information of a user. Here, the meaning of "the screen display area 220A includes the sensing area 220B" may be understood to mean that at least a portion of the sensing area 220B may be overlapped on the screen display area 220A. For example, the sensing area 220B, like other areas of the screen display area 220A, may refer to an area in which visual information may be displayed by the display 220 and additionally biometric information (e.g., fingerprint) of a user may be obtained. In an embodiment, the sensing area 220B may be formed in the key input device 217.

In an embodiment, the display 220 may include an area in which the first camera module 205 (e.g., a camera module 180 of FIG. 1) is positioned. In an embodiment, an opening may be formed in the area of the display 220, and the first camera module 205 (e.g., a punch hole camera) may be at least partially disposed in the opening to face the first surface 200A. In this case, the screen display area 220A may surround at least a portion of the periphery of the opening. In an embodiment, the first camera module 205 (e.g., an under display camera (UDC)) may be disposed under the display 220 to overlap the area of the display 220. In this case, the display 220 may provide visual information to the user through the area, and additionally, the first camera module 205 may obtain an image corresponding to a direction facing the first surface 200A through the area of the display 220.

In an embodiment, the display 220 may be coupled to or disposed adjacent to a touch sensing circuit, a pressure sensor capable of measuring the intensity (pressure) of the touch, and/or a digitizer that detects a magnetic field type stylus pen.

In an embodiment, the audio modules 203, 204 and 207 (e.g., an audio module 170 of FIG. 1) may include microphone holes 203 and 204 and a speaker hole 207.

In an embodiment, the microphone holes 203 and 204 may include a first microphone hole 203 formed in a partial area of the third surface 200C and a second microphone hole 204 formed in a partial area of the second surface 200B. A microphone (not illustrated) for obtaining an external sound may be disposed inside the microphone holes 203 and 204. The microphone may include a plurality of microphones to detect the direction of sound.

In an embodiment, the second microphone hole 204 formed in a partial area of the second surface 200B may be disposed adjacent to the camera modules 205, 212 and 213. For example, the second microphone hole 204 may obtain sound according to operations of the camera modules 205, 212, and 213. However, it is not limited thereto.

In an embodiment, the speaker hole 207 may include an external speaker hole 207 and a receiver hole (not illustrated) for a call. The external speaker hole 207 may be formed on a portion of the third surface 200C of the electronic device 200. In an embodiment, the external speaker hole 207 may be implemented as one hole with the microphone hole 203. Although not illustrated, a receiver hole (not illustrated) for a call may be formed on another portion of the third surface 200C. For example, the receiver hole for a call may be formed on the opposite side of the external speaker hole 207 on the third surface 200C. For example, based on the illustration of FIG. 2, the external speaker hole 207 may be formed on the third surface 200C corresponding to the lower end of the electronic device 200, and the receiver hole for a call may be formed on the third surface 200C corresponding to the upper end of the electronic device 200. However, the present invention is not limited thereto, and in an embodiment, the receiver hole for a call may be formed at a position other than the third surface 200C. For example, the receiver hole for a call may be formed by a space spaced apart between the front plate 202 (or display 220) and the side bezel structure 218.

In an embodiment, the electronic device 200 may include at least one speaker (not illustrated) configured to output sound to the outside of the housing 210 through an external speaker hole 207 and/or a receiver hole (not illustrated) for a call.

In an embodiment, the sensor module (not illustrated) (e.g., a sensor module 176 of FIG. 1) may generate an electrical signal or data value corresponding to an internal operating state or an external environmental state of the electronic device 200. For example, the sensor module may include at least one of a proximity sensor, an HRM sensor, a fingerprint sensor, a gesture sensor, a gyro sensor, a pressure sensor, a magnetic sensor, an acceleration sensor, a grip sensor, a color sensor, an infrared (IR) sensor, a biometric sensor, a temperature sensor, a humidity sensor, and an illumination sensor.

In an embodiment, the camera modules 205, 212 and 213 (e.g., a camera module 180 of FIG. 1) may include a first camera module 205 disposed to face the first surface 200A of the electronic device 200, a second camera module 212 disposed to face the second surface 200B, and a flash 213.

In an embodiment, the second camera module 212 may include a plurality of cameras (e.g., a dual camera, a triple camera, or a quad camera). However, the second camera module 212 is not necessarily limited to including a plurality of cameras, and may include one camera.

In an embodiment, the first camera module 205 and the second camera module 212 may include one or a plurality of lenses, an image sensor, and/or an image signal processor.

In an embodiment, the flash 213 may include, for example, a light emitting diode or a xenon lamp. In an embodiment, two or more lenses (infrared camera, wide-angle and telephoto lens) and image sensors may be disposed on one side of electronic device 200.

In an embodiment, the key input device 217 (e.g., an input module 150 of FIG. 1) may be disposed on the third surface 200C of the electronic device 200. In an embodiment, the electronic device 200 may not include some or all of the key input devices 217, and the not included key input device 217 may be implemented on the display 220 in another form such as a soft key.

In an embodiment, the connector hole 208 may be formed on the third surface 200C of the electronic device 200 to accommodate the connector of the external device. A connection terminal (e.g., a connection terminal 178 of FIG. 1) electrically connected to the connector of the external device may be disposed in the connector hole 208. The electronic device 200 according to an embodiment may include an interface module (e.g., an interface 177 of FIG. 1) for processing electrical signals transmitted and received through the connection terminal.

In an embodiment, the electronic device 200 may include a light emitting device (not illustrated). For example, the light emitting device (not illustrated) may be disposed on the first surface 200A of the housing 210. The light emitting device (not illustrated) may provide state information of the electronic device 200 in a form of light. In an embodiment, the light emitting device (not illustrated) may provide a light source when the first camera module 205 is operated. For example, the light emitting device (not illustrated) may include an LED, an IR LED, and/or a xenon lamp.

FIG. 3 is an exploded perspective view of an electronic device according to an embodiment.

Hereinafter, overlapping descriptions of components having the same reference numerals as those of the above-described components will be omitted.

Referring to FIG. 3, the electronic device 200 according to an embodiment may include a frame structure 240, a first printed circuit board 250, a second printed circuit board 252, a cover plate 260, and a battery 270.

In an embodiment, the frame structure 240 may include a sidewall 241 forming an exterior (e.g., the third surface 200C of FIG. 2) of the electronic device 200 and a support portion 243 extending inward from the sidewall 241. In an embodiment, the frame structure 240 may be disposed between the display 220 and the rear plate 211. In an embodiment, the sidewall 241 of the frame structure 240 may surround a space between the rear plate 211 and the front plate 202 (and/or the display 220), and the support portion 243 of the frame structure 240 may extend from the sidewall 241 within the space.

In an embodiment, the frame structure 240 may support or accommodate other components included in the electronic device 200. For example, the display 220 may be disposed on one surface of the frame structure 240 facing one direction (e.g., the +z direction), and the display 220 may be supported by the support portion 243 of the frame structure 240. For example, a first printed circuit board 250, a second printed circuit board 252, a battery 270, and a second camera module 212 may be disposed on the other surface facing a direction opposite to the one direction (e.g., the -z direction) of the frame structure 240. The first printed circuit board 250, the second printed circuit board 252, the battery 270, and the second camera module 212 may be mounted on a recess defined by the sidewall 241 and/or the support portion 243 of the frame structure 240.

In an embodiment, the first printed circuit board 250, the second printed circuit board 252, and the battery 270 may be coupled to the frame structure 240, respectively. For example, the first printed circuit board 250 and the second printed circuit board 252 may be fixedly disposed in the frame structure 240 through a coupling member such as a screw. For example, the battery 270 may be fixedly disposed on the frame structure 240 through an adhesive member (e.g., a double-sided tape). However, it is not limited by the above-described example.

In an embodiment, a cover plate 260 may be disposed between the first printed circuit board 250 and the rear plate 211. In an embodiment, the cover plate 260 may be disposed on the first printed circuit board 250. For example, the cover plate 260 may be disposed on a surface facing the -z direction of the first printed circuit board 250.

In an embodiment, the cover plate 260 may at least partially overlap the first printed circuit board 250 with respect to the z-axis. In an embodiment, the cover plate 260 may cover at least a partial area of the first printed circuit board 250. Through this, the cover plate 260 may protect the first printed circuit board 250 from physical impact or prevent the connector coupled to the first printed circuit board 250 from being separated.

In an embodiment, the cover plate 260 may be fixedly disposed on the first printed circuit board 250 through a coupling member (e.g., a screw), or may be coupled to the frame structure 240 together with the first printed circuit board 250 through the coupling member.

In an embodiment, the display 220 may be disposed between the frame structure 240 and the front plate 202. For example, a front plate 202 may be disposed on one side (e.g., a +z direction) of the display 220 and a frame structure 240 may be disposed on the other side (e.g., a - z direction).

In an embodiment, the front plate 202 may be coupled to the display 220. For example, the front plate 202 and the display 220 may adhere to each other through an optical adhesive member (e.g., optically clear adhesive (OCA) or optically clear resin (OCR)) interposed therebetween.

In an embodiment, the front plate 202 may be coupled to the frame structure 240. For example, the front plate 202 may include an outside portion extending outside the display 220 when viewed in the z-axis direction, and may adhere to the frame structure 240 through an adhesive member (e.g., a double-sided tape) disposed between the outside portion of the front plate 202 and the frame structure 240 (e.g., the sidewall 241). However, it is not limited by the above-described example.

In an embodiment, the first printed circuit board 250 and/or the second printed circuit board 252 may be equipped with a processor (e.g., a processor 120 of FIG. 1), a memory (e.g., a memory 130 of FIG. 1), and/or an interface (e.g., an interface 177 of FIG. 1). The processor may include, for example, one or more of a central processing unit, an application processor, a graphic processing unit, an image signal processor, a sensor hub processor, or a communication processor. The memory may include, for example, a volatile memory or a nonvolatile memory. The interface may include, for example, a high definition multimedia interface (HDMI), a universal serial bus (USB) interface, an SD card interface, and/or an audio interface. The interface may electrically or physically connect the electronic device 200 to an external electronic device, and may include a USB connector, an SD card/MMC connector, or an audio connector. In an embodiment, the first printed circuit board 250 and the second printed circuit board 252 may be operatively or electrically connected to each other through a connection member (e.g., a flexible printed circuit board).

In an embodiment, the battery 270 may supply power to at least one component of the electronic device 200. For example, the battery 270 may include a rechargeable secondary cell or a fuel cell. At least a portion of the battery 270 may be disposed on substantially the same plane as the first printed circuit board 250 and/or the second printed circuit board 252.

The electronic device 200 according to an embodiment may include an antenna module (not illustrated) (e.g., an antenna module 197 of FIG. 1). In an embodiment, the antenna module may be disposed between the rear plate 211 and the battery 270. The antenna module may include, for example, a near field communication (NFC) antenna, a wireless charging antenna, and/or a magnetic secure transmission (MST) antenna. The antenna module, for example, may perform short-range communication with an external device, or wirelessly transmit and receive power to and from the external device.

In an embodiment, the first camera module 205 (e.g., a front camera) may be disposed in at least a portion (e.g., a support portion 243) of the frame structure 240 so that the lens may receive external light through a partial area (e.g., a camera area 137 of FIG. 2) of the front plate 202.

In an embodiment, the second camera module 212 (e.g., a rear camera) may be disposed between the frame structure 240 and the rear plate 211. In an embodiment, the second camera module 212 may be electrically connected to the first printed circuit board 250 through a connection member (e.g., a connector). In an embodiment, the second camera module 212 may be disposed such that the lens may receive external light through a camera area 284 of the rear plate 211 of the electronic device 200.

In an embodiment, the camera area 284 may be formed on the surface (e.g., a rear surface 200B of FIG. 2) of the rear plate 211. In an embodiment, the camera area 284 may be formed to be at least partially transparent so that external light may be incident to the lens of the second camera module 212. In an embodiment, at least a portion of the camera area 284 may protrude from the surface of the rear plate 211 to a predetermined height. However, it is not limited to thereto, and in an embodiment, the camera area 284 may form a plane substantially the same as the surface of the rear plate 211.

In an embodiment, the housing of the electronic device 200 may mean a configuration or structure forming at least a portion of the exterior of the electronic device 200. In this regard, at least a portion of the front plate 202, the frame structure 240, and/or the rear plate 211 forming the exterior of the electronic device 200 may be referred to as the housing of the electronic device 200.

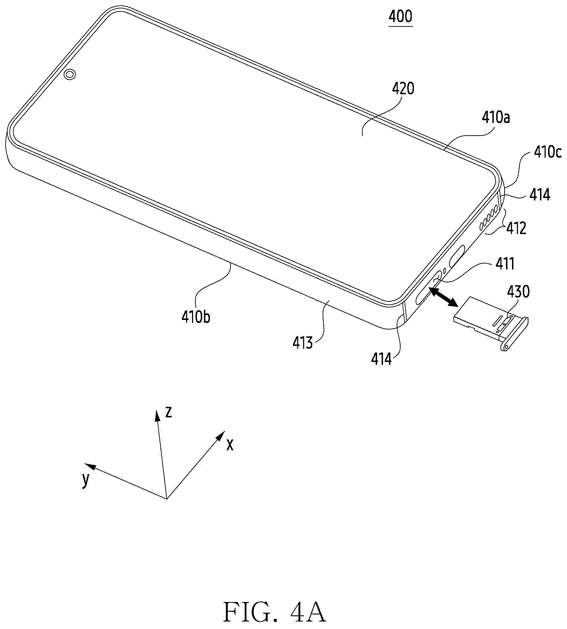

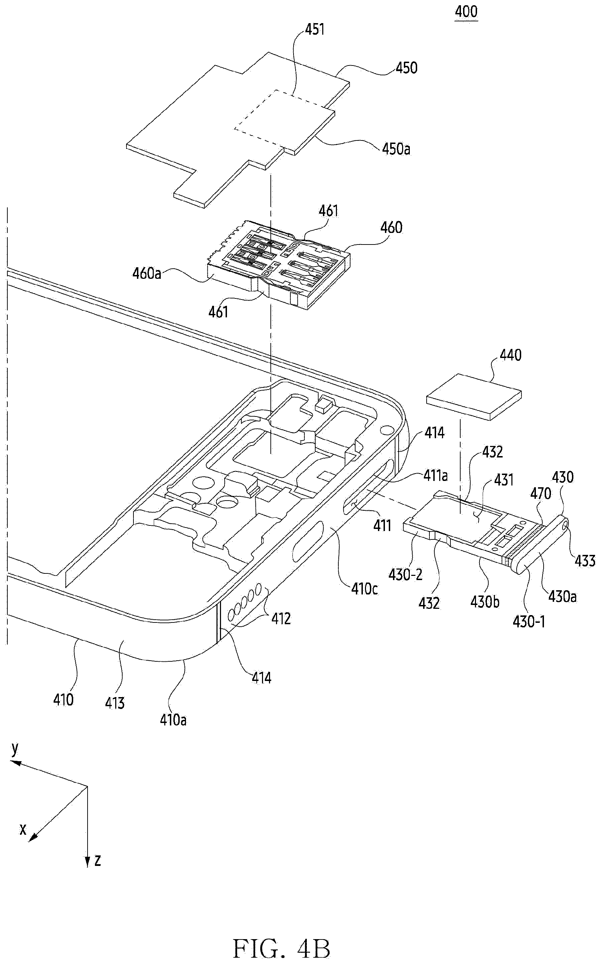

FIG. 4A is a perspective view of an exemplary electronic device according to an embodiment. FIG. 4B is an exploded perspective view of an exemplary electronic device according to an embodiment.

Referring to FIG. 4A and FIG. 4B, according to an embodiment, the electronic device 400 may include a housing 410, a display 420 (e.g., the display module 160 in FIG. 1, and/or the display 201 in FIG. 2 and FIG. 3), an tray 430, a printed circuit board 450, an interface socket 460, and/or a sealing member 470.

The housing 410 may define at least a part of an outer surface of the electronic device 400. The housing 410 may provide a space in which components of the electronic device 400 may be accommodated. The housing 410 may support components of the electronic device 400. For example, a first surface 410a of the housing 410 may support the display 420. A second surface 410b of the housing 410 opposite to the first surface 410a of the housing 410 may define a part of the outer surface of the electronic device 400. For example, the second surface 410b of the housing 410 may define a rear surface of the electronic device 400. A direction (e.g., in the -z direction) in which the second surface 410b faces may be opposite to a direction (e.g., in the +z direction) in which the first surface 410a faces. The second surface 410b may be spaced apart from the first surface 410a. For example, the second surface 410b may be substantially parallel to the first surface 410a in a state spaced apart from the first surface 410a. A side surface 410c of the housing 410 may connect the first surface 410a and the second surface 410b of the housing 410. For example, the side surface 410c may cover (or surround) a periphery of the first surface 410a and a periphery of the second surface 410b. According to an embodiment, the side surface 410c may be substantially perpendicular to the first surface 410a and the second surface 410b. However, it is not limited thereto, and the side surface 410c may have a curvature and a curved shape. According to an embodiment, the housing 410 may include a through-hole 411, a plurality of speaker holes 412, at least one conductive portion 413, and/or a plurality of non-conductive portions 414.

The through-hole 411 may provide a passage through which the tray 430 may move into the housing 410. The through-hole 411 may provide a passage through which the tray 430 may move to the outside of the housing 410. According to an embodiment, the through-hole 411 may penetrate the housing 410. For example, the through-hole 411 may penetrate the side surface 410c of the housing 410. The through-hole 411 may connect the outside of the housing 410 and the inside of the housing 410. For example, the through-hole 411 may extend toward the inside of the housing 410 from the side surface 410c of the housing 410 that provides the outer surface of the electronic device 400. According to an embodiment, the through-hole 411 may have a shape corresponding to a shape of at least a part of the tray 430. For example, the through-hole 411 refer to an opening.

A plurality of speaker holes 412 may transmit audio outputted from a speaker (e.g., the audio module 170 of FIG. 1) disposed within the housing 410 to the outside of the housing 410. According to an embodiment, the plurality of speaker holes 412 may penetrate the housing 410. For example, the plurality of speaker holes 412 may penetrate the side surface 410c of the housing 410. According to an embodiment, the plurality of speaker holes 412 may be spaced apart from each other. The plurality of speaker holes 412 may be spaced apart from the through-hole 411.

At least one conductive portion 413 may function as an antenna radiator. For example, a wireless communication circuit of the electronic device 400 (e.g., the wireless communication module 192 of FIG. 1) may be electrically (or operably) connected to at least one conductive portion 413. The wireless communication circuit may be configured to communicate with an external electronic device in a designated frequency band through the at least one conductive portion 413. For example, the designated frequency band may be referred to as a low band (e.g., a frequency band of about 1 GHz or less), but is not limited thereto. The at least one conductive portion 413 may mean a part of the housing 410 including a conductive material.

The plurality of non-conductive portions 414 may segment the at least one conductive portion 413. According to an embodiment, the plurality of non-conductive portions 414 may be exposed through the side surface 410c of the housing 410. The plurality of non-conductive portions 414 may be spaced apart from each other. For example, the through-hole 411 and the plurality of speaker holes 412 may be disposed between the plurality of non-conductive portions 414.

The display 420 may be configured to provide visual information. For example, the display 420 may be configured to emit light for providing visual information along a direction in which the first surface 410a of the housing 410 faces (e.g., the +z direction). According to an embodiment, the display 420 may be coupled to the housing 410. For example, the display 420 may be disposed on the first surface 410a of the housing 410.

According to an embodiment, the tray 430 may support or accommodate an interface chip 440. The tray 430 may be referred to as a SIM or interface bracket tray capable of accommodating an interface chip 440 such as a subscriber identification module (SIM) card, a universal subscriber identity module (USIM) card, and or secure digital card (SD card), but is not limited thereto. For example, the tray 430 may include an accommodating groove 431 for accommodating the interface chip 440. The accommodating groove 431 may receive or cover the interface chip 440. For example, the accommodating groove 431 may refer to an empty space formed by a part of the tray 430 being depressed inward. According to an embodiment, the tray 430 may be detachably coupled to the housing 410. The tray 430 may be detachably coupled to the housing 410 through the through-hole 411. For example, the tray 430 may be inserted into the through-hole 411 of the housing 410. For example, the tray 430 may be pulled out from the through-hole 411 of the housing 410. According to an embodiment, the tray 430 may be movable with respect to the housing 410. For example, the tray 430 may be moved towards the outside of the through-hole 411 of the housing 410 and removed by moving in a first direction (e.g., the -y direction). For example, the tray 430 may be inserted into the through-hole 411 to be accommodated in the electronic device 400, by moving in a second direction (e.g., the +y direction) opposite to the first direction. For example, at least a part of the tray 430 may be disposed on (or disposed to make contact with) the printed circuit board 450 by moving in the second direction. For example, at least a part of the tray 430 may face (and/or make contact with) the printed circuit board 450 by moving in the second direction.

According to an embodiment, the tray 430 may include an outer surface 430a. The outer surface 430a of the tray 430 may be exposed to the outside of the housing 410 in a state that the tray 430 is inserted into the through-hole 411. For example, the outer surface 430a may be exposed in a first direction (e.g., may be visible to an observer located in the first direction, e.g., the -y direction). For example, the outer surface 430a of the tray 430 may have a shape corresponding to the shape of the side surface 410c of the housing 410. For example, the outer surface 430a of the tray 430 may substantially define one plane with the side surface 410c of the housing 410, in the state in which the tray 430 is inserted into the through-hole 411. For example, the tray 430 may face the first direction (e.g., a -y direction).

According to an embodiment, the tray 430 may include a coupling portion 432. The coupling portion 432 may maintain the coupling of the tray 430 and the interface socket 460. According to an embodiment, the coupling portion 432 may be disposed on the side surface 430b of the tray 430. The side surface 430b of the tray 430 may face a direction perpendicular to the first direction (e.g., the -y direction).

According to an embodiment, the tray 430 may include a first accommodating hole 433 for insertion of an external member. For example, the first accommodating hole 433 refers to a first hole. For example, the external member may be a part of a tool for releasing the tray 430. The first accommodating hole 433 may accommodate an external member to release the coupling between the housing 410 and the tray 430. For example, the user may separate the tray 430 and the housing 410 by inserting the external member into the first accommodating hole 433. For example, when the tray 430 is inserted into the through-hole 411 such that the outer surface 430a of the tray 430 substantially defines one plane with the side surface 410c of the housing 410, the user may insert the external member into the first accommodating hole 433 to create a separation between the plane of the side surface 410c and the outer surface 430a of the tray, to allow the user to more easily grasp and remove the tray 430. As explained in more detail below, the tray may be configured such that the separation mechanism is contained mostly or entirely within the tray 430. Consequently, more space may be provided within the electronic device 400 and/or a manufacturing cost/complexity of the electronic device may be reduced. For example, more space may be provided on the printed circuit board 450 for disposing electronic components. For example, more space may be provided on side surface 410c, which may allow for improvements in the sizing and/or spacing of the plurality of non-conductive portions 414 and the at least one conductive portion 413. The first accommodating hole 433 may penetrate the tray 430. For example, the first accommodating hole 433 may penetrate the outer surface 430a of the tray 430 exposed to the outside of the housing 410. For example, the first accommodating hole 433 may connect the outside of the tray 430 and the inside of the tray 430.

According to an embodiment, the tray 430 may include a head part 430-1 and/or a body part 430-2. The head part 430-1 may be exposed to the outside of the housing 410 while the tray 430 is inserted into the housing 410. For example, the head part 430-1 may include an outer surface 430a and/or a first accommodation hole 433. The body part 430-2 may be connected to the head part 430-1. The body part 430-2 may support the interface chip 440. The body part 430-2 may indicate a part of the tray 430 accommodating the interface chip 440. For example, while the tray 430 is inserted into the housing 410, the body part 430-2 may not be exposed to the outside of the housing 410. The body part 430-2 may be coupled to the head part 430-1. For example, the body part 430-2 may be inserted into the head part 430-1 and coupled in a snap-fit method but is not limited thereto. For example, the body part 430-2 may be integrally formed with the head part 430-1.

The interface chip 440 may be configured to store data on an identifier for identifying a subscriber of a network (e.g., the second network 199) for long-distance wireless communication of the electronic device 400. For example, the interface chip 440 may be configured to store data for implementing short-range wireless communication (e.g., near field communication (NFC)) of the electronic device 400. For example, the interface chip 440 may include data required for operation of a software (e.g., an application) of the electronic device 400. The data required for operation of the software may include at least one of information on identification information (e.g., phone number) of other electronic devices that may communicate with the electronic device 400, and information for the user's financial payment, but it is not limited thereto. According to an embodiment, the interface chip 440 may be referred to as a subscriber identification module (SIM) card, a universal subscriber identity module (USIM) card, and/or a secure digital card (SD card), but is not limited thereto.

According to an embodiment, the interface chip 440 may be disposed on the tray 430. The interface chip 440 may be movable together with the tray 430. The interface chip 440 may be electrically connected to the printed circuit board 450, in the state that the tray 430 is inserted into the through-hole 411. The interface chip 440 may receive or transmit data through the printed circuit board 450, by being electrically connected to the printed circuit board 450.

The printed circuit board 450 may establish an electrical connection of electronic components in the electronic device 400. For example, the printed circuit board 450 may electrically connect the interface chip 440 and a processor (e.g., the processor 120 in FIG. 1). According to an embodiment, the printed circuit board 450 may include an interface circuit 451 disposed on one surface 450a of the printed circuit board 450. The interface circuit 451 may be electrically connected to the interface chip 440, in a state in which the tray 430 and the interface chip 440 are inserted into the through-hole 411. The interface circuit 451 may receive data from the interface chip 440 or transmit data to the interface chip 440. According to an embodiment, the printed circuit board 450 may be disposed in the housing 410. For example, the one surface 450a of the printed circuit board 450 may face the second surface 410b in the housing 410.

The interface socket 460 may accommodate the tray 430. For example, the tray 430 may be inserted into the inside of the interface socket 460, by moving in the second direction (e.g., the +y direction). For example, the tray 430 may move to the outside of the interface socket 460, by moving in the first direction (e.g., the -y direction). According to an embodiment, the interface socket 460 may be coupled to the printed circuit board 450. For example, the interface socket 460 may be disposed on the one surface 450a of the printed circuit board 450.

According to an embodiment, the interface socket 460 may support the tray 430 inserted into the through-hole 411. For example, the interface socket 460 may include a hooking portion 461. The hooking portion 461 may be disposed on a side surface 460a of the interface socket 460. The side surface 460a of the interface socket 460 may face a direction (e.g., the -x direction or the +x direction) perpendicular to the first direction (e.g., the -y direction). The hooking portion 461 may have a shape corresponding to the coupling portion 432 of the tray 430. The coupling portion 432 may have a shape corresponding to the hooking portion 461. According to an embodiment, the hooking portion 461 may be coupled to the coupling portion 432 of the tray 430, in the state that the tray 430 is inserted into the interface socket 460. The hooking portion 461 may be in contact with the coupling portion 432 of the tray 430, in the state that the tray 430 is inserted into the interface socket 460. According to an embodiment, the hooking portion 461 may be deformable. The hooking portion 461 may be deformable by contact with the tray 430. For example, as the tray 430 moves in the second direction (e.g., the +y direction), the hooking portion 461 may be pressurized by the tray 430. As the hooking portion 461 is pressurized in the second direction by the tray 430, the hooking portion 461 may move in a direction facing the outside of the interface socket 460. The hooking portion 461 may face the coupling portion 432 after moving in the direction facing the outside of the interface socket 460. As facing the coupling portion 432, the hooking portion 461 may be in contact with the coupling portion 432, by moving in the direction facing the inside of the interface socket 460. As the hooking portion 461 and the coupling portion 432 are in contact, the state in which the tray 430 is inserted into the through-hole 411 may be maintained.

The sealing member 470 may seal the through-hole 411. The sealing member 470 may reduce inflow of foreign substances (e.g., moisture) to the through-hole 411. According to an embodiment, the sealing member 470 may be coupled to the tray 430. The sealing member 470 may surround the tray 430. The sealing member 470 may cover the tray 430. According to an embodiment, in the state that the tray 430 is inserted into the through-hole 411, the sealing member 470 may fill the through-hole 411. For example, the sealing member 470 may be in contact with an inner surface 411a of the through-hole 411. For example, the sealing member 470 may include a deformable material (e.g., rubber) having elasticity, but is not limited thereto.

For example, for replacement of the interface chip 440, the tray 430 may include a releasing structure for releasing coupling with the interface socket 460. Due to a space occupied by the releasing structure, a space on the printed circuit board 450 for disposing electronic components may be reduced. When the size of the outer surface 430a of the tray 430 expands, a distance between the plurality of non-conductive portions 414 that must be reduced to improve the communication efficiency of the electronic device 400 may be increased, due to the size of the releasing structure. Hereinafter, a structure for releasing coupling of the tray 430 and the interface socket 460 while securing a space in the electronic device 400 will be described.

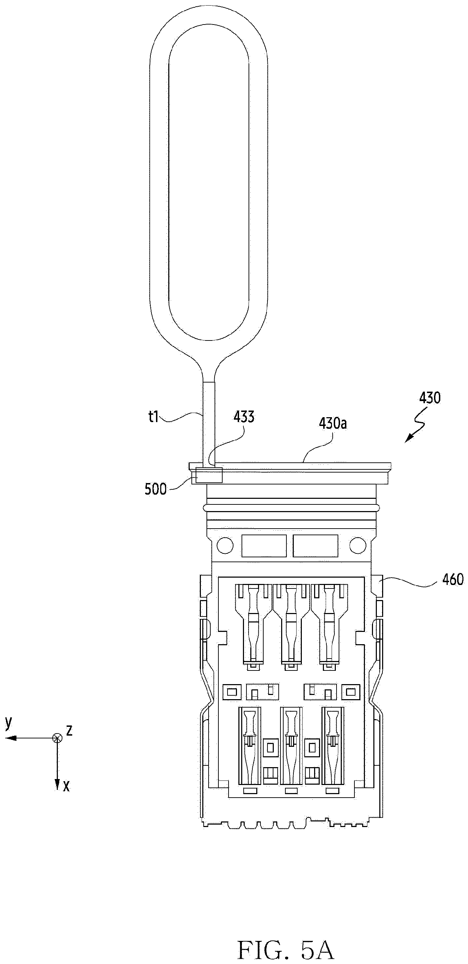

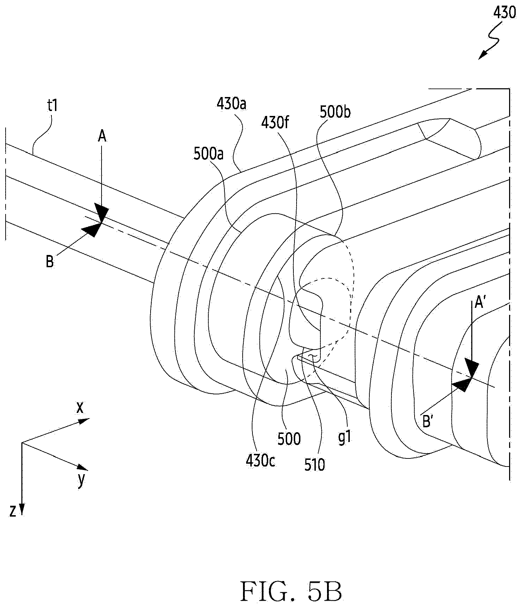

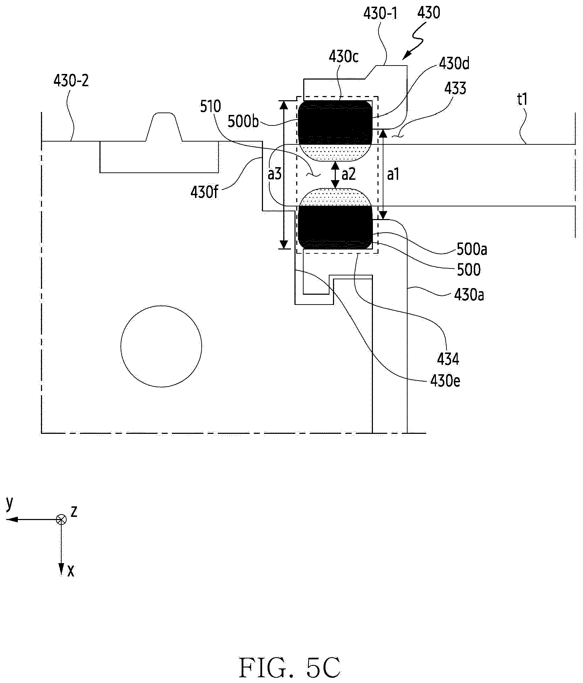

FIG. 5A is a top plan view of an exemplary tray according to an embodiment. FIG. 5B is an enlarged perspective view enlarging a part of an exemplary tray according to an embodiment. FIG. 5C is a cross-sectional view illustrating an example in which an exemplary tray is cut along A-A' of FIG. 5B, according to an embodiment.

Referring to FIGS. 5A and 5B, according to an embodiment, an external member t1 may be inserted into the first accommodating hole 433 of the tray 430. For example, the external member t1 may be referred to as an eject tool for releasing the tray 430 from through-hole (e.g., the through-hole 411 of FIG. 4A and FIG. 4B). Releasing the tray 430 may comprise creating a separation between the plane of the side surface 410c and the outer surface 430a of the tray, to allow the user to more easily grasp and remove the tray 430. In some examples, releasing the tray 430 may comprise releasing a coupling with the electronic device 400, for example releasing a coupling with the interface socket 460. Although the first accommodating hole 433 in FIG. 5A is illustrated as being positioned near an edge of the outer surface 430a of the tray 430, it will be appreciated that the first accommodating hole 433 may be positioned anywhere on the outer surface 430a, for example in the middle, at the other edge, or any other position. An advantage of the release structure described herein is that the first accommodating hole 433 is not required to align with any structures or components within the electronic device and hence can be freely positioned on the outer surface 430a of the tray 430, which may allow for reductions in the size, fragility, and/or manufacturing complexity of the tray 430, for example. According to an embodiment, the first accommodating hole 433 may have a first cross-sectional area a1. A cross-sectional area may refer to the size of a cross-section of one component when viewing the one component in a direction in which the outer surface 430a of the tray 430 (e.g., a +y direction or a second direction) faces, and unless otherwise stated, corresponding expression may be used equally below. The first cross-sectional area a1 of the first accommodating hole 433 may be greater than or equal to a cross-sectional area of the external member t1. For example, the first cross-sectional area a1 may be larger than the cross-sectional area of the external member t1. For example, the first cross-sectional area a1 may be substantially the same as the size of the cross-sectional area of the external member t1. As the first cross-sectional area a1 of the first accommodating hole 433 is greater than or equal to the cross-sectional area of the external member t1, the external member t1 may be inserted into the first accommodating hole 433. For example, the external member t1 may have a circular cross-sectional area with a certain diameter (e.g., 0.7 mm) and the first cross-sectional area a1 of the first accommodating hole 433 may be circular with a diameter greater than or equal to the diameter of the external member t1.

According to an embodiment, the tray 430 may include an elastic member 500. The elastic member 500 may comprise an elastic material, for example rubber or urethane. The elastic member 500 may be deformable by the external member t1. The elastic member 500 may accommodate the external member t1. For example, the elastic member 500 may include an insertion hole 510. For example, the insertion hole 510 refers to a second hole. The insertion hole 510 may penetrate the elastic member 500. For example, the insertion hole 510 may extend from one end (or surface) 500a of the elastic member 500 to another end (or surface) 500b of the elastic member 500. At least a part of one end 500a of the elastic member 500 may be exposed to the outside of the tray 430 through the first accommodating hole 433. According to an embodiment, the first accommodating hole 433 may be close to the one end 500a among the one end 500a and the other end 500b of the elastic member 500. For example, the one end 500a of the elastic member 500 may face the first direction (e.g., the -y direction). The other end 500b of the elastic member 500 may be opposite to the one end 500a of the elastic member 500. For example, a direction (e.g., +y direction) in which the other end 500b of the elastic member 500 faces may be opposite to a direction (e.g., -y direction) in which the one end 500a of the elastic member 500 faces. For example, the other end 500b of the elastic member 500 may face the second direction (e.g., the +y direction). According to an embodiment, the insertion hole 510 may have a second cross-sectional area a2 smaller than the first cross-sectional area a1 of the first accommodating hole 433. For example, a diameter of the insertion hole 510 may be smaller than a diameter of the first accommodating hole 433. The second cross-sectional area a2 may be smaller than the size of the external member t1. For example, the second cross-sectional area a2 in the state before the external member t1 is inserted may be smaller than the size of the external member t1. For example, the second cross-sectional area a2 in the state before the external member t1 is inserted may be smaller than the cross-sectional area of the external member t1. For example, the diameter of the insertion hole 510 in the state before the external member t1 is inserted may be smaller than the size (e.g., the diameter) of the external member t1. As the cross-sectional area of the insertion hole 510 is smaller than the cross-sectional area of the external member t1, the elastic member 500 may be deformed by the external member t1 to expand the size (or cross-sectional area) of the insertion hole 510. For example, as the cross-sectional area of the insertion hole 510 is smaller than the cross-sectional area of the external member t1, when the external member t1 is inserted into the insertion hole 510, the elastic member 500 can be deformed along the radial direction of the insertion hole 510. The radiation direction of one component may indicate a direction away from the center of one component. When the external member t1 is removed from the insertion hole 510, the cross-sectional area of the insertion hole 510 can be restored to the second cross-sectional area a2, which is smaller than the cross-sectional area of the external member t1. As the cross-sectional area of the insertion hole 510 is smaller than the size of the external member t1, the elastic member 500 may deform along the radial direction of the insertion hole 510 while the external member t1 is inserted into the insertion hole 510. The radiation direction of one component may indicate a direction away from the center of one component. According to an embodiment, the insertion hole 510 may be connected to the first accommodating hole 433. As the insertion hole 510 is connected to the first accommodating hole 433, the external member t1 penetrating the first accommodating hole 433 may be inserted into the insertion hole 510.

According to an embodiment, the elastic member 500 may be coupled to the head part 430-1 of the tray 430. For example, the elastic member 500 may be disposed in the head part 430-1 of the tray 430. For example, the elastic member 500 may be covered (or surrounded) by the head part 430-1 of the tray 430. However, it is not limited thereto. For example, the elastic member 500 may be coupled to the body part 430-2.

According to an embodiment, the elastic member 500 may be disposed within the tray 430. The tray 430 may include a second accommodating hole 434 for accommodating the elastic member 500. For example, the second accommodating hole 434 refers to a third hole. The second accommodating hole 434 may surround the elastic member 500. The second accommodating hole 434 may cover part of the elastic member 500. The second accommodating hole 434 may be connected to the first accommodating hole 433 within the tray 430. According to an embodiment, the second accommodating hole 434 may have a third cross-sectional area a3 larger than the first cross-sectional area a1 of the first accommodating hole 433. For example, a diameter of the second accommodating hole 434 may be larger than the diameter of the first accommodating hole 433. As the size of the second accommodating hole 434 is larger than the size of the first accommodating hole 433, the movement of the elastic member 500 that fills the second accommodating hole 434 in the first direction (e.g., the -y direction) may be limited. As the size of the second accommodating hole 434 is larger than the size of the first accommodating hole 433, a position of the elastic member 500 in the tray 430 may be maintained.

According to an embodiment, the tray 430 may include an inner surface 430c. The inner surface 430c may form an inner surface of the second accommodating hole 434. According to an embodiment, the inner surface 430c may surround the outer surface of the elastic member 500. For example, the inner surface 430c may extend along the outer surface of the elastic member 500. According to an embodiment, the inner surface 430c may be in contact with the elastic member 500. As the inner surface 430c and the elastic member 500 are in contact, the position of the elastic member 500 in the tray 430 may be maintained. According to an embodiment, the inner surface 430c may have a shape corresponding to the shape of the elastic member 500. For example, the inner surface 430c may be curved with a curvature. For example, the curvature of the inner surface 430c may correspond to the curvature of an outer surface of elastic member 500.

According to an embodiment, the tray 430 may include a first supporting surface 430d and a second supporting surface 430e. The first supporting surface 430d may support the elastic member 500. For example, the first supporting surface 430d may limit the movement of the elastic member 500 in the first direction (e.g., the -y direction). According to an embodiment, the first supporting surface 430d may be disposed within the tray 430. For example, the first supporting surface 430d may be connected to the inner surface 430c of the tray 430 covering the outer surface of the elastic member 500. For example, the first supporting surface 430d may be substantially perpendicular to the inner surface 430c of the tray 430. The first supporting surface 430d may face the second direction (e.g., the +y direction). According to an embodiment, the first supporting surface 430d may support at least a part of one end 500a of the elastic member 500. The first supporting surface 430d may face the one end 500a of the elastic member 500. For example, the first supporting surface 430d may be in contact with the one end 500a of the elastic member 500. According to an embodiment, the first accommodating hole 433 may extend from the outer surface 430a of the tray 430 to the first supporting surface 430d. For example, the first accommodating hole 433 may extend from the outer surface 430a of the tray 430 to the first supporting surface 430d in the second direction (e.g., the +y direction).

The second supporting surface 430e may support the elastic member 500. The second supporting surface 430e may support at least a part of the other end 500b of the elastic member 500. For example, the second supporting surface 430e may limit the movement of the elastic member 500 in the second direction (e.g., the +y direction). According to an embodiment, the second supporting surface 430e may be disposed within the tray 430. The second supporting surface 430e may face at least a part of the first supporting surface 430d. For example, the second supporting surface 430e may be spaced apart from the first supporting surface 430d in the second direction (e.g., the +y direction). According to an embodiment, the second supporting surface 430e may face at least a part of the other end 500b of the elastic member 500. For example, the second supporting surface 430e may be in contact with the other end 500b of the elastic member 500. For example, the second supporting surface 430e may be spaced apart from the other end 500b of the elastic member 500. According to an embodiment, the second supporting surface 430e may be disposed outside the insertion hole 510 when viewing the elastic member 500 in the second direction (e.g., the +y direction). For example, the second supporting surface 430e may not overlap the insertion hole 510 when viewing the elastic member 500 in the second direction (e.g., the +y direction).

According to an embodiment, the external member t1 moving in the second direction (e.g., the +y direction) may be inserted into the insertion hole 510 by penetrating through the first accommodating hole 433. While the external member t1 is inserted into the insertion hole 510, the elastic member 500 may be pressurized in the second direction by the external member t1. The second supporting surface 430e supporting the other end 500b of the elastic member 500 may limit the movement of the elastic member 500 in the second direction. According to an embodiment, as the external member t1 is inserted into the insertion hole 510, the tray 430 may be movable to the outside of a through-hole (e.g., the through-hole 411 of FIG. 4A and FIG. 4B). The external member t1 inserted into the insertion hole 510 may be in contact with the elastic member 500. When the external member t1 is inserted into the insertion hole 510, the elastic member 500 may be in close contact with the external member t1. When the external member t1 is inserted into the insertion hole 510, the elastic member 500 may holed the external member t1. When the external member t1 is inserted into the insertion hole 510, the elastic member 500 may grip the external member t1. When the external member t1 is inserted into the insertion hole 510, the elastic member 500 may clasp the external member. As the external member t1 inserted into the insertion hole 510 and the elastic member 500 are in contact with each other, the elastic member 500 may be movable with the external member t1. After the external member t1 is inserted into the insertion hole 510, the external member t1 may move in the first direction (e.g., the -y direction). Due to the movement of the external member t1 in the first direction, the one end 500a of the elastic member 500 may pressurize the first supporting surface 430d in the first direction. As the first supporting surface 430d is pressurized in the first direction, the tray 430 may move in the first direction facing the outside of the through-hole 411. As the tray 430 moves in the first direction, the tray 430 and the housing (e.g., the housing 410 of FIG. 4A and FIG. 4B) may be separated. For example, a separation between the plane of the side surface 410c and the outer surface 430a of the tray may be created by the movement of the tray in the first direction, to allow the user to more easily grasp and remove the tray 430. According to an embodiment, the electronic device (e.g., the electronic device 400 of FIG. 4A and FIG. 4B) may provide a structure that may save a space within the housing 410, by the elastic member 500 in contact with the external member t1 for releasing the coupling (or creating a separation) between the tray 430 and the housing 410. For example, since the coupling between the tray 430 and the housing 410 may be released through the elastic member 500 disposed within the tray 430, the electronic device 400 (e.g., the interface socket 460) may not include a structure for releasing the coupling between the tray 430 and the housing 410. Since the electronic device 400 (e.g., interface socket 460) does not include a structure (or mechanism) for releasing the coupling or creating a separation between the tray 430 and the housing 410, a space within the housing 410 may be saved.

According to an embodiment, the tray 430 may include a seating surface 430f. The seating surface 430f may be spaced apart from the elastic member 500. For example, the seating surface 430f may be spaced apart from the elastic member 500 along the second direction (e.g., the +y direction). For example, the second supporting surface 430e may be spaced apart from the other end 500b of the elastic member 500 by a first distance, and the seating surface 430f may be spaced apart from the other end 500b of the elastic member 500 by a second distance longer than the first distance. According to an embodiment, the seating surface 430f may face the other end 500b of the elastic member 500. For example, the seating surface 430f may face the first direction (e.g., the -y direction). For example, when viewing the elastic member 500 in the second direction, the seating surface 430f may overlap the insertion hole 510. A position of the seating surface 430f may correspond to a position of the insertion hole 510. According to an embodiment, as the seating surface 430f is spaced apart from the other end 500b of the elastic member 500, a gap g1 may be disposed between the seating surface 430f and the other end 500b of the elastic member 500. As the gap g1 is formed between the seating surface 430f and the other end 500b of the elastic member 500, a part of the external member t1 may penetrate through the insertion hole 510. A part of the external member t1 penetrating through the insertion hole 510 may be disposed within the gap g1 between the seating surface 430f and the elastic member 500. The external member t1 penetrating through the insertion hole 510 may face the seating surface 430f. For example, in order for the external member t1 to be in close contact with the insertion hole 510, the external member t1 is required to penetrate through the insertion hole 510. According to an embodiment, since the seating surface 430f is spaced apart from the elastic member 500, the electronic device 400 may provide a structure in which the external member t1 may penetrate through the insertion hole 510 and positioned into the gap g1.

As described above, according to an embodiment, the electronic device 400 may provide a structure in which the coupling between the tray 430 and the housing 410 may be released through the elastic member 500. According to an embodiment, since the tray 430 and the housing 410 may be released through a relatively simple structure, the electronic device 400 may provide a structure capable of securing a space in which other components may be disposed in the housing 410.

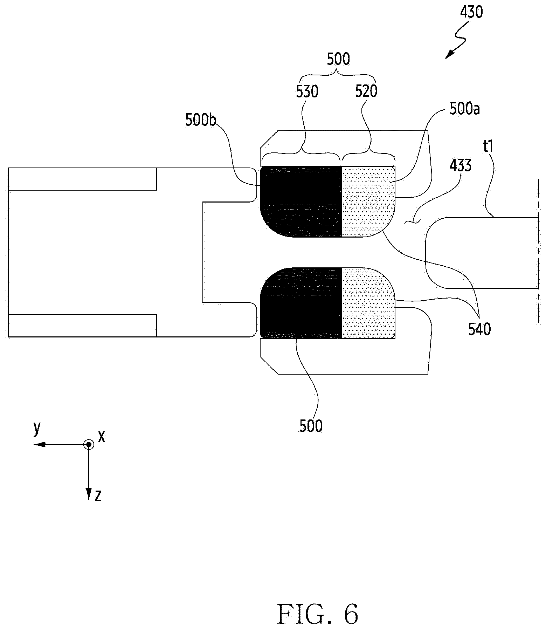

FIG. 6 is a cross-sectional view illustrating an example in which an exemplary tray is cut along B-B' of FIG. 5B, according to an embodiment.

Referring to FIG. 6, according to an embodiment, the elastic member 500 may include a first region 520 and/or a second region 530. The first region 520 may be partially exposed to the outside of the tray 430 through the first accommodating hole 433. According to an embodiment, the first region 520 may include a material different from the second region 530. For example, the first region 520 may have rigidity greater than the second region 530. The first region 520 may include one end 500a of the elastic member 500. The first region 520 may define one end 500a of the elastic member 500.

The second region 530 may be connected to the first region 520. According to an embodiment, the second region 530 may extend from the first region 520. For example, the second region 530 may extend from the first region 520 in the second direction (e.g., the +y direction). According to an embodiment, the second region 530 may include the other end 500b of the elastic member 500. The second region 530 may define the other end 500b of the elastic member 500. According to an embodiment, the second region 530 may have a rigidity lower than the first region 520. For example, the second region 530 may be deformed more than the first region 520 by the external member t1. For example, the first region 520 may be weaker to an impact transmitted from the external member t1 than the second region 530. According to an embodiment, since rigidity of the first region 520 is greater than the second region 530, the tray 430 may provide a structure capable of reducing damage to the elastic member 500.

According to an embodiment, the elastic member 500 may include a curved surface 540. The curbed surface 540 may guide a movement of the external member t1 within the elastic member 500. The curved surface 540 may be curved with a slope with respect to the first direction (e.g., the -y direction). The curved surface 540 may curved with a curvature in the first direction. According to an embodiment, the curved surface 540 may be disposed at the one end 500a of the elastic member 500, but is not limited thereto. For example, the curved surface 540 may be disposed at the other end 500b of the elastic member 500.

As described above, according to an embodiment, the tray 430 may provide a structure capable of reducing damage to the elastic member 500 by the first region 520 having a rigidity greater than the second region 530. According to an embodiment, the tray 430 may provide a structure capable of guiding the movement of the external member t1 by the curved surface 540 curved in the first direction.

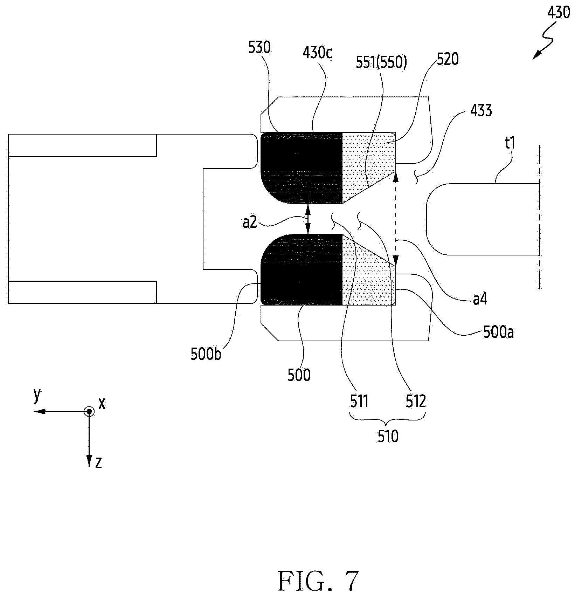

FIG 7 is a cross-sectional view illustrating an example in which an exemplary tray is cut, according to an embodiment.

Referring to FIG. 7, according to an embodiment, the elastic member 500 may include at least one inclined surface 550. The at least one inclined surface 550 may guide a movement of the external member t1. The at least one inclined surface 550 may be inclined with respect to the first direction (e.g., the -y direction). For example, the at least one inclined surface 550 may extend in a direction closer to the inner surface 430c of the tray 430 while inclining to the first direction (e.g., the -y direction). For example, the at least one inclined surface 550 may extend in a direction away from the inner surface 430c of the tray 430. The at least one inclined surface 550 may surround at least a part of the insertion hole 510. According to an embodiment, the at least one inclined surface 550 may include a first inclined surface 551.

The first inclined surface 551 may be close to the one end 500a of the elastic member 500, among the one end 500a of the elastic member 500 and the other end 500b of the elastic member 500. The first inclined surface 551 may extend from the one end 500a of the elastic member 500. For example, the first inclined surface 551 may extend from the one end 500a of the elastic member 500, in the second direction (e.g., +y direction). According to an embodiment, as extending from the one end 500a of the elastic member 500 in the second direction, the first inclined surface 551 may be further away from the inner surface 430c of the tray 430. For example, as the first inclined surface 551 extends from the one end 500a of the elastic member 500 in the second direction, a distance between the first inclined surface 551 and the inner surface 430c of the tray 430 may further increase. According to an embodiment, the first inclined surface 551 may be disposed within the first region 520 of the elastic member 500.

According to an embodiment, a cross-sectional area of the insertion hole 510 may be changed within the tray 430. For example, the insertion hole 510 may include a first extending region 511 and a second extending region 512. The first extending region 511 may extend while having a second cross-sectional area a2. According to an embodiment, the first extending region 511 may extend from the other end 500b of the elastic member 500 in the first direction (e.g., the -y direction). For example, the first extending region 511 may extend while maintaining the second cross-sectional area a2. According to an embodiment, the first extending region 511 may be disposed within the second region 530. For example, the first extending region 511 may be surrounded by the second region 530.

The second extending region 512 may be connected to the first extending region 511. One end of the second extending region 512 connected to the first extending region 511 may have the second cross-sectional area a2. According to an embodiment, the second extending region 512 may extend from the first extending region 511 in the first direction (e.g., the -y direction). As extending in the first direction (e.g. -y direction), the cross-sectional area of the second extending region 512 may further increase. For example, the cross-sectional area of the second extending region 512 may increase linearly as extending in the first direction, but is not limited thereto. For example, the other end of the second extending region 512 opposite to the one end of the second extending region 512 may have a fourth cross-sectional area a4 larger than the second cross-sectional area a2. The other end of the second extending region 512 may be exposed to the outside of the tray 430 through the first accommodating hole 433. The fourth cross-sectional area a4 may be larger than the size of the external member t1. As the other end of the second extending region 512 is larger than the size of the external member t1, damage to the elastic member 500 due to the movement of the external member t1 in the second direction (e.g., the +y direction) may be reduced. As the other end of the second extending region 512 is larger than the size of the external member t1, damage to the one end 500a of the elastic member 500 by the external member t1 may be reduced.

As described above, according to an embodiment, the tray 430 may provide a structure capable of guiding the movement of the external member t1 by the at least one inclined surface 550 inclined with respect to the first direction. According to an embodiment, since the cross-sectional area of the other end of the second extending region 512 of the insertion hole 510 is larger than the size of the external member t1, the tray 430 may provide a structure capable of reducing damage to the elastic member 500 by the external member 11.

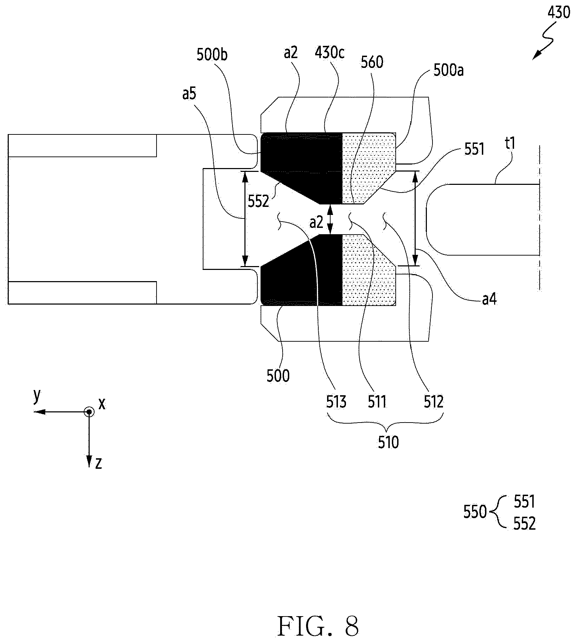

FIG 8 is a cross-sectional view illustrating an example in which an exemplary tray is cut, according to an embodiment.

Referring to FIG. 8, at least one inclined surface 550 may include a second inclined surface 552. The second inclined surface 552 may extend from the other end 500b of the elastic member 500 in the first direction (e.g., the -y direction). For example, as extending from the other end 500b of the elastic member 500 in the first direction, the second inclined surface 552 may be further away from the inner surface 430c of the tray 430. For example, as the second inclined surface 552 extends from the other end 500b of the elastic member 500 in the first direction, a distance between the second inclined surface 552 and the inner surface 430c of the tray 430 may increase.

According to an embodiment, the elastic member 500 may include a connection surface 560. The connection surface 560 may be disposed between the first inclined surface 551 and the second inclined surface 552. For example, the connection surface 560 may extend from the second inclined surface 552 to the first inclined surface 551 in the first direction (e.g., the -y direction). According to an embodiment, a distance between the connection surface 560 and the inner surface 430c of the tray 430 may be substantially constant while the connection surface 560 extends in the first direction.

According to an embodiment, the insertion hole 510 may include a third extending region 513. The third extending region 513 may be spaced apart from the second extending region 512. For example, the third extending region 513 may be spaced apart from the second extending region 512 in the second direction (e.g., +y direction). For example, the first extending region 511 may be disposed between the second extending region 512 and the third extending region 513. The third extending region 513 may extend from the other end 500b of the elastic member 500 to the first extending region 511 along the first direction (e.g., the -y direction). According to an embodiment, the third extending region 513 may be connected to the first extending region 511. For example, one end of the third extending region 513 connected to the first extending region 511 may have the second cross-sectional area a2. The other end of the third extending region 513 opposite to the one end of the third extending region 513 may have a fifth cross-sectional area a5 greater than the second cross-sectional area a2. The size of the fifth cross-sectional portion a5 may be substantially the same as the size of the fourth cross-sectional part a4, but it is not limited thereto. For example, the size of the fifth cross-sectional area a5 may be greater than the size of the fourth cross-sectional area a4. For example, the size of the fifth cross-sectional area a5 may be smaller than the size of the fourth cross-sectional area a4. According to an embodiment, the size of the fifth cross-sectional area a5 may be greater than the size of the external member t1. As the size of the fifth cross-sectional area a5 is greater than the size of the external member t1, damage to the elastic member 500 due to movement of the external member t1 in the first direction (e.g., the -y direction) may be reduced. As the size of the fifth cross-sectional area a5 is greater than the size of the external member t1, damage to the other end 500b of the elastic member 500 by the external member t1 may be reduced.

As described above, according to an embodiment, the tray 430 may provide a structure capable of guiding the movement of the external member t1 by the second inclined surface inclined with respect to the first direction. According to an embodiment, the tray 430 may provide a structure capable of reducing damage to the elastic member 500 by the external member t1, by the other end of the third extending region 513 having the fifth cross-sectional area a5 greater than the size of the external member t1.

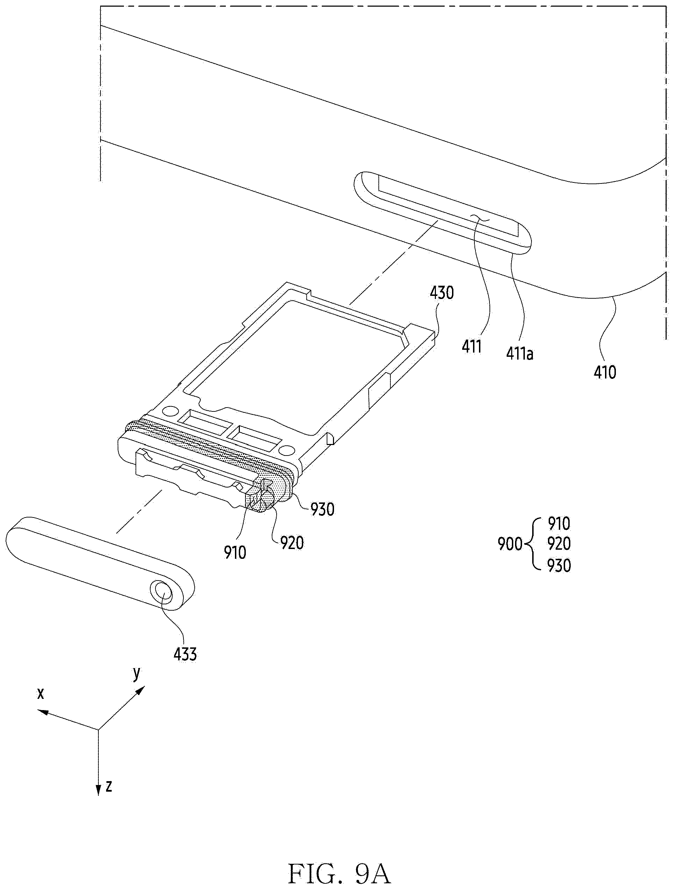

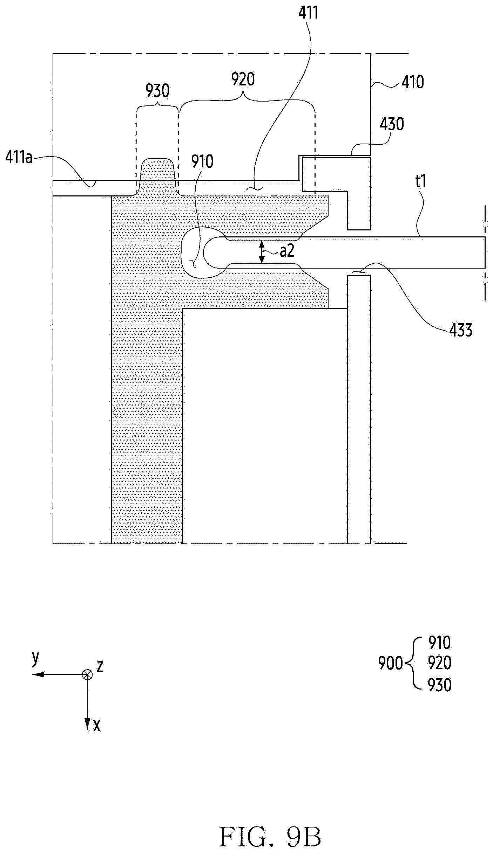

FIG. 9A is an exploded perspective view of an exemplary tray according to an embodiment. FIG. 9B is a cross-sectional view illustrating an example in which an exemplary tray is cut along C-C' of FIG. 9A, according to an embodiment.

Referring to FIG. 9A and FIG. 9B, according to an embodiment, the tray 430 may include an elastic member 900. The elastic member 900 may be coupled to the tray 430. For example, a part of the elastic member 900 may surround the tray 430. Since the elastic member 900 of FIG. 9 may be substantially the same as the elastic member 500 of FIGS. 5B and 5C, repeated description will be omitted. According to an embodiment, the elastic member 900 may include an insertion hole 910, a deformable region 920, and/or a sealing region 930. Since the insertion hole 910 of FIG. 9 may be substantially the same as the insertion hole 510 of FIGS. 5B and 5C, repeated description will be omitted.

The insertion hole 910 may have a second cross-sectional area a2. The size of the second cross-sectional area a2 may be smaller than the size of the external member t1. As the second cross-sectional area a2 is smaller than the size of the external member t1, the elastic member 900 may be in contact with the external member t1 inserted into the insertion hole 910. The elastic member 900 may be in close contact with the external member t1 inserted into the insertion hole 910. As the elastic member 900 and the external member t1 are in contact with each other, the elastic member 900 may move with the external member t1. As the elastic member 900 and external member t1 move together, the tray 430 may be movable to the outside of the through-hole 411. For example, the insertion hole 910 may refer to a second hole.

The deformable region 920 may surround the insertion hole 910. For example, the deformable region 920 may define the insertion hole 910. The deformable region 920 may be deformable by the external member t1. According to an embodiment, the deformable region 920 may cover the external member t1 in the state in which the external member t1 is inserted into the insertion hole 910. For example, the deformable region 920 may be in contact with the external member t1 in the state in which the external member t1 is inserted into the insertion hole 910. According to an embodiment, the deformable region 920 may include different materials. For example, one end of the deformable region 920 adjacent to the first accommodating hole 433 may include a rigid material, or a material with greater rigidity than material of the other end. The other end of the deformable region 920 opposite to the one end of the deformable region 920 may include a flexible material, or a material having greater flexibility than the material of the one end. However, it is not limited thereto.

The sealing region 930 may seal the through-hole 411. For example, the sealing region 930 may be in contact with the inner surface 411a of the through-hole 411. The sealing region 930 may fill a gap between the inner surface 411a of the through-hole 411 and the tray 430, in the state in which the tray 430 is inserted into the through-hole 411. For example, the sealing region 930 may have a cross-sectional area larger than the cross-sectional area of the through-hole 411. As the sealing region 930 has a cross-sectional area greater than the through-hole 411, the sealing region 930 may be deformable when the tray 430 is inserted into the through-hole 411. The sealing region 930 may be deformed to fill the gap between the inner surface 411a of the through-hole 411 and the tray 430. The sealing region 930 of FIGS. 9A and 9B may be substantially the same as the sealing member 470 of FIGS. 4A and 4B, and repeated description will be omitted. According to an embodiment, the sealing region 930 may be connected to the deformable region 920. For example, the sealing region 930 may be formed integrally with the deformable region 920. According to an embodiment, since the tray 430 and the housing 410 may be released through a relatively simple structure by forming integrally the sealing region 930 for sealing the through-hole 411 and the deformable region 920 for accommodating the external member t1, the electronic device 400 may provide a structure capable of securing a space within the housing 410. Furthermore, by integrally forming the sealing region 930 for sealing the through-hole 411 and the deformable region 920 for accommodating the external member t1, a manufacturing complexity and/or cost may be reduced.

As described above, according to an embodiment, the electronic device 400 may provide a structure capable of easily moving the tray 430 by the external member t1, by the deformable region 920 integrally formed with the sealing region 930 for sealing the through-hole 411.

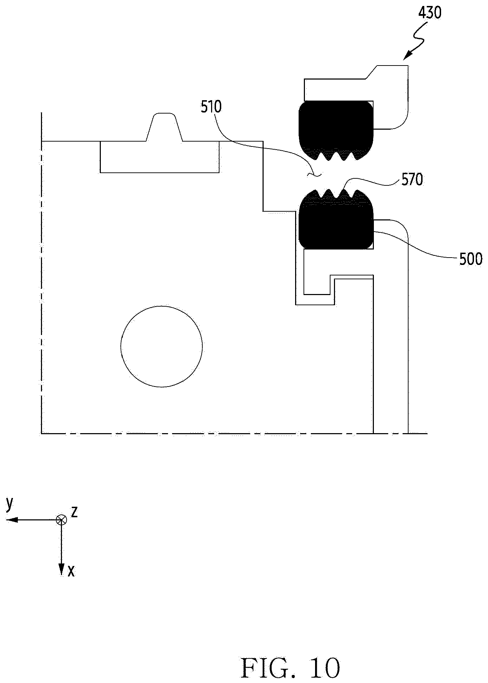

FIG. 10 is a cross-sectional view of an exemplary tray according to an embodiment.

Since the tray of FIG. 10 may be a tray 430 with a changed structure of the elastic member 500 in the tray 430 of FIG. 5A, 5B, and 5C, a redundant description will be omitted.

Referring to FIG. 10, according to an embodiment, the elastic member 500 may include a plurality of protrusions 570. A plurality of protrusions 570 may be disposed in the insertion hole 510. For example, a plurality of protrusions 570 may be disposed along the insertion hole 510. As a plurality of protrusions 570 are formed, a contact area between the elastic member 500 and the external member t1 may increase. As the contact part between the elastic member (500) and the external member (t1) increases, the elastic member (500) can easily hold the external member (t1).

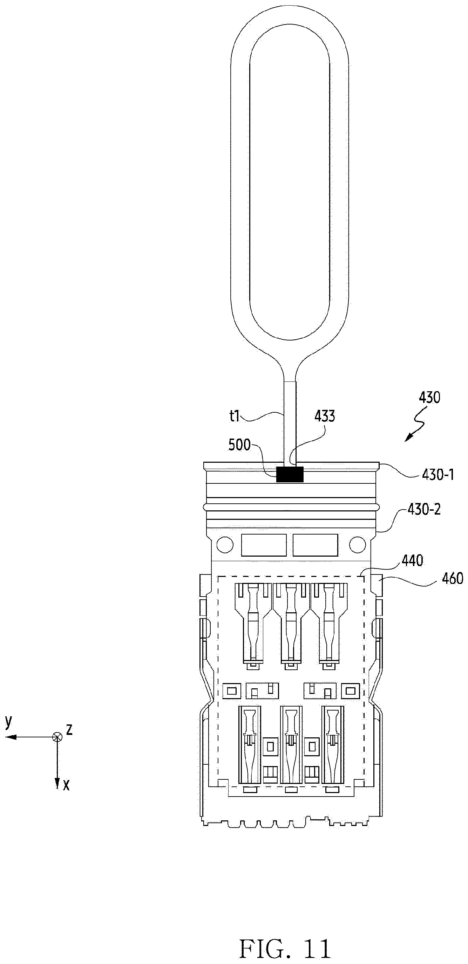

FIG. 11 is a cross-sectional view of an exemplary tray and an exemplary interface socket according to an embodiment.

The tray of FIG. 11 may be a tray 430 in which the positions of the elastic member 500 and the first accommodating hole 433 are changed in the tray 430 of FIGS. 5A, 5B, and 5C, and thus a repeated description thereof will be omitted.

Referring to Fig. 11, the size of the head part 430-1 of the tray 430 may be substantially the same as the size of the body part 430-2. For example, the size of the cross-sectional area of the head part 430-1 may be substantially the same as the size of the cross-sectional area of the body part 430-2.

According to an embodiment, the positions of the elastic member 500 and the first accommodating hole 433 may be aligned with the center of the head part 430-1. For example, the position of the elastic member 500 and the first accommodating hole 433 may be aligned with the interface chip 440 while the tray 430 is inserted into the interface socket 460. For example, the elastic member 500 and the first receiving hole 433 may overlap to the interface chip 440 while the tray 430 is inserted into the interface socket 460.

A tray may be detachably coupled to a housing defining an outer surface of an electronic device. As the tray of the electronic device is detachably coupled, an interface chip accommodated in the tray may be replaced. For the replacement of the interface chip, the electronic device may include a structure for separating the tray and the housing. As the structure for separating the tray and the housing is disposed in the housing, a space in which other components may be disposed in the housing may be reduced. The electronic device may require a structure capable of detachably coupling the tray to the housing while securing a space within the housing. Such a structure may be provided by the tray described herein.

According to an embodiment, an electronic device (e.g., the electronic device 400 of FIG. 4A and FIG. 4B) may include a housing (e.g., the housing 410 of FIG. 4A and FIG. 4B) including an opening (e.g., the through-hole 411 of FIG. 4A and FIG. 4B). According to an embodiment, the electronic device may include a tray (e.g., the tray 430 of FIG. 4A and FIG. 4B) configured to inserted into the housing through the opening. According to an embodiment, the tray may include a first hole (e.g., the first accommodating hole 433 of FIG. 5C) exposed to outside of the housing. According to an embodiment, the tray may include an elastic member (e.g., the elastic member 500 of FIG. 5C) including a second hole aligned with the first hole and disposed in the housing while the tray is inserted into the housing. According to an embodiment, the elastic member is configured to at least partially hold (or grip, or clasp) an external member(e.g., the external member t1 of FIG. 5A, FIG. 5B, and FIG. 5C) so as to at least partially eject the tray from inside of the housing to the outside of the housing according to the external member, held by the external member, being moved.

According to an embodiment, a cross-sectional area of the second hole is smaller than a cross-sectional area of the external member before the external member is inserted into the second hole. According to an embodiment, the elastic member is configured to at least partially hold the external member by being deformed to expand the cross-sectional area of the second hole.

According to an embodiment, the tray includes a head part on which the elastic member is disposed and including a first hole. According to an embodiment, the tray includes a body part coupled to (or coupled with) the head part and configured to accommodate (or support) an interface chip.

According to an embodiment, an electronic device (e.g., the electronic device 400 of FIG. 4A and FIG. 4B) may include a housing (e.g., the housing 410 of FIG. 4A and FIG. 4B) including a through-hole (e.g., the through-hole 411 of FIG. 4A and FIG. 4B). According to an embodiment, the electronic device may include a printed circuit board (e.g., the printed circuit board 450 of FIG. 4B) disposed in the housing. According to an embodiment, the electronic device may include an tray (e.g., the tray 430 of FIG. 4A and FIG. 4B) in which at least a part is disposed on the printed circuit board by moving in a second direction to be inserted into the through-hole or that moves outside of the through-hole by moving in a first direction. According to an embodiment, the tray may include a first accommodating hole (e.g., the first accommodating hole 433 of FIG. 5C) for inserting of an external member (e.g., the external member t1 of FIG. 5A, FIG. 5B, and FIG. 5C) penetrating an outer surface (e.g., the outer surface 430a of FIG. 4A and FIG. 4B) of the tray exposed to outside of the housing and having a first cross-sectional area (e.g., the first cross-sectional area a1 of FIG. 5C). According to an embodiment, the tray may include an elastic member (e.g., the elastic member 500 of FIG. 5C) deformable by the external member and including an insertion hole (e.g., the insertion hole 510 of FIG. 5C) having a second cross-sectional area (e.g., the second cross-sectional area a2 of FIG. 5C) smaller than the first cross-sectional area. According to an embodiment, the tray may be movable to the outside of the housing by a movement of the external member in contact with the elastic member in the first direction by being inserted into the insertion hole.

According to an embodiment, the electronic device may provide a structure in which the coupling of the tray and the housing may be released through the elastic member.

According to an embodiment, the tray may include a first supporting surface (e.g., the first supporting surface 430d of FIG. 5C) within the tray facing the second direction and supporting at least part of one end (e.g., the one end 500a of FIG. 5C) of the elastic member. According to an embodiment, the tray may include a second supporting surface (e.g., the second supporting surface 430e of FIG. 5C) within the tray facing the first supporting surface and supporting the other end (e.g., the other end 500b of FIG. 5C) of the elastic member opposite to the one end of the elastic member. According to an embodiment, the through-hole may extend from the outer surface to the first supporting surface.

According to an embodiment, the electronic device may provide a structure capable of blocking the movement of the first accommodating hole of the elastic member to the outside, by the first supporting surface and the second supporting surface supporting the elastic member in opposite directions.

According to an embodiment, the tray may include a seating surface (e.g., the seating surface 430f of FIG. 5C) within the tray spaced apart from the elastic member along the second direction. According to an embodiment, a part of the external member may be disposed within a gap (e.g., the gap g1 of FIG. 5C) between the elastic member and the seating surface by being inserted into the insertion hole.

According to an embodiment, the electronic device may provide a structure in which the external member may be inserted at a designated distance or more through a gap between a seating surface and an elastic member.

According to an embodiment, a part of the elastic member may be exposed to outside of the tray through the first accommodating hole.

According to an embodiment, the electronic device may provide a structure capable of accommodating the external member by the elastic member partially exposed through the first accommodating hole.

According to an embodiment, the tray may include a second accommodating hole (e.g., the second accommodating hole 434 of FIG. 5C) connected to the first accommodating hole and having a third cross-sectional area larger than the first cross-sectional area. According to an embodiment, the elastic member may fill the second accommodating hole.

According to an embodiment, the electronic device may provide a structure capable of blocking the movement of the first accommodating hole of the elastic member to the outside, by the second accommodating hole having the size larger than the first accommodating hole.

According to an embodiment, the housing may include a first surface (e.g., the first surface 410a of FIG. 4A). According to an embodiment, the housing may include a second surface (e.g., the second surface 410b of FIG. 4A) opposite to the first surface. According to an embodiment, the housing may include a side surface (e.g., the side surface 410c of FIG. 4A) connecting the first surface and the second surface. According to an embodiment, the through-hole may penetrate the side surface.

According to an embodiment, the electronic device may provide a structure in which the tray is detachably coupled to the housing through the side surface of the housing.

According to an embodiment, the electronic device may include an interface socket (e.g., the interface socket 460 of FIG. 4B) disposed on one surface of the printed circuit board and covering the tray inserted into the through-hole.

According to an embodiment, the electronic device may provide a structure capable of supporting the tray within the housing by the interface socket covering the tray.

According to an embodiment, the interface socket may include hooking portion (e.g., the hooking portion 461 of FIG. 4B) deformable by the tray. According to an embodiment, the tray may include a coupling portion (e.g., the coupling portion 432 of FIG. 4B) disposed on a side surface of the tray facing a direction perpendicular to a first direction, the coupling portion is in contact with the hooking portion by having a shape corresponding to the hooking portion.

According to an embodiment, the electronic device may provide a structure in which the coupling between the tray and the interface socket may be maintained, by the hooking portion of the interface socket that is in contact with the coupling portion of the tray.

According to an embodiment, the electronic device may include an interface chip (e.g., the interface chip 440 of FIG. 4B) coupled to the tray and facing the printed circuit board, in a state that the tray is inserted in the through-hole. According to an embodiment, the printed circuit board may include an interface circuit (e.g., the interface circuit 451 of FIG. 4B) disposed on one surface of the printed circuit board and electrically connected to the interface chip.

According to an embodiment, the electronic device may receive information from the interface chip or transmit information to the interface chip, by the interface circuit electrically connected to the interface chip.

According to an embodiment, the elastic member may include a deformable region (e.g., the deformable region 920 of FIG. 9A and FIG. 9B) surrounding the insertion hole. According to an embodiment, the elastic member may include a sealing region (e.g., the sealing region 930 of FIG. 9A and FIG. 9B) connected to the deformable region and in contact with an inner surface of the through-hole, in a state that the tray is inserted in the through-hole.

According to an embodiment, the electronic device may provide a structure in which the coupling between the tray and the housing may be easily released by the external member, by the deformable region integrally formed with the sealing region for sealing the through-hole.

According to an embodiment, the elastic member may include a first region (e.g., the first region 520 of FIG. 6) that is partially exposed to outside of the tray through the first accommodating hole. According to an embodiment, the elastic member may include a second region (e.g., the second region 530 of FIG. 6) extending from the first region along the second direction and having a rigidity lower than the first region.

According to an embodiment, the electronic device may provide a structure capable of reducing damage to the elastic member by the external member, by the first region having a rigidity higher than the second region.

According to an embodiment, the elastic member may include a curved surface (e.g., the curved surface 540 of FIG. 6) curved with a curvature with respect to the first direction and exposed to outside of the tray through the first accommodating hole.

According to an embodiment, the electronic device may provide a structure capable of reducing damage to the elastic member by the external member, by the curved surface curved with a curvature.

According to an embodiment, the elastic member may include at least one inclined surface (e.g., the at least one inclined surface 550 of FIG. 7) inclined with respect to the first direction and surrounding the insertion hole.

According to an embodiment, the electronic device may provide a structure capable of guiding movement of the external member, by at least one inclined surface inclined with respect to the first direction parallel to the moving direction of the external member.

According to an embodiment, the tray may include an inner surface (e.g., the inner surface 430c of FIG. 5C) surrounding an outer surface of the elastic member. According to an embodiment, the at least one inclined surface may include a first inclined surface (e.g., the first inclined surface 551 of FIG. 7) extending in a direction away from the inner surface. According to an embodiment, the at least one inclined surface may include a second inclined surface (e.g., the second inclined surface 553 of FIG. 7) extending in a direction close to the inner surface.

According to an embodiment, the electronic device may provide a structure capable of guiding movement of the external member, by the first inclined surface and the second inclined surface inclined with respect to the first direction parallel to the moving direction of the external member.

According to an embodiment, the insertion hole may include a first extending region (e.g., the first extending region 511 in FIG. 7) having the second cross-sectional area. According to an embodiment, the insertion hole may include a second extending region (e.g., second extending region 512 in FIG. 7) in which one end connected to the first extending region has the second cross-sectional area and the other end exposed to outside of the tray through the first accommodating hole has a fourth cross-sectional area larger than the second cross-sectional area.

According to an embodiment, the electronic device may provide a structure capable of reducing damage to the elastic member by the external member, by the second extending region having the fourth cross-sectional area larger than the second cross-sectional area.

According to an embodiment, an electronic device (e.g., the electronic device 400 of FIG. 4A and FIG. 4B) may comprise a housing (e.g., the housing 410 of FIG. 4A and FIG. 4B) including a through-hole (e.g., the through-hole 411 of FIG. 4A and FIG. 4B). According to an embodiment, the electronic device may comprise a printed circuit board (e.g., the printed circuit board (450) of FIG. 4B) disposed in the housing. According to an embodiment, the electronic device may comprise a tray (e.g., the tray 430 of FIG. 4A and FIG. 4B) moving outside of the through-hole by moving along a first direction or disposed on the printed circuit board by moving along a second direction to be inserted into the through-hole. According to an embodiment, the tray may include an outer surface (e.g., the outer surface 430a of FIG. 4A and FIG. 4B) exposed to outside of the housing, in a state that the tray is inserted into the through-hole. According to an embodiment, the tray (e.g., the first supporting surface 430d of FIG. 5C) may include a first supporting surface within the tray facing the second direction. According to an embodiment, the tray may include a first accommodating hole (e.g., the first accommodating hole 433 of FIG. 5C) for insertion of an external member extending from the outer surface to the first supporting surface, and having a first cross-sectional area (e.g., the first cross-sectional area (a1) of FIG. 5C). According to an embodiment, the tray may include an elastic member (e.g., the elastic member 500 of FIG. 5C) including an insertion hole (e.g., the insertion hole 510 of FIG. 5C) having a second cross-sectional area (e.g., the second cross-sectional area a2 of FIG. 5C) smaller than the first cross-sectional area, and at least part of one end of the elastic member is supported by the first supporting surface. According to an embodiment, the tray may include a second supporting surface (e.g., the second supporting surface 430e of FIG. 5C) within the tray facing the first supporting surface and supporting at least part of the other end (e.g., the other end 500b of FIG. 5C) of the elastic member opposite to the one end of the elastic member. According to an embodiment, the tray may be movable to the outside of the through-hole by a movement of the external member in contact with the elastic member in the first direction by being inserted into the insertion hole.

According to an embodiment, the electronic device may provide a structure in which the coupling of the tray and the housing may be released through the elastic member. According to an embodiment, the electronic device may provide a structure capable of blocking the movement of the first accommodating hole of the elastic member to the outside, by the first supporting surface and the second supporting surface supporting the elastic member in opposite directions.

According to an embodiment, the tray may include a seating surface (e.g., the seating surface 430f of FIG. 5C) within the tray spaced apart from the elastic member along the second direction and facing the second supporting surface. According to an embodiment, a part of the external member may be disposed within a gap (e.g., the gap g1 of FIG. 5C) between the elastic member and the seating surface by being inserted into the insertion hole.

According to an embodiment, the at least part of the one end of the elastic member may be exposed to the outside of the tray through the first accommodating hole.

According to an embodiment, the electronic device may include an interface socket (e.g., the interface socket 460 of FIG. 4B) covering the tray inserted into the through-hole and disposed on one surface of the printed circuit board.

According to an embodiment, the electronic device may provide a structure in which the external member may be inserted at a designated distance or more through the gap between the seating surface and the elastic member.

According to an embodiment, the electronic device may include an interface chip (e.g., the interface chip 440 of FIG. 4B) coupled to the tray and facing the printed circuit board, in a state that the tray is inserted in the through-hole. According to an embodiment, the printed circuit board may include an interface circuit (e.g., the interface circuit 451 of FIG. 4B) disposed on one surface of the printed circuit board and electrically connected to the interface chip.

According to an embodiment, the electronic device may receive information from the interface chip or transmit information to the interface chip by the interface circuit electrically connected to the interface chip.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

In a first example, there is provided an tray configured to be removably accommodated in an electronic device, the tray comprising: an outer surface configured to be exposed in a first direction when the tray is accommodated in the electronic device; a first accommodating hole provided in the outer surface, wherein the first accommodating hole has a first cross-sectional area and is configured to receive an external member; and an elastic member comprising an insertion hole, wherein the insertion hole has a second cross-sectional area smaller than the first cross-sectional area and is configured to receive the external member, and wherein the insertion hole is exposed in the first direction through the first accommodating hole; wherein the elastic member is configured to deform such that the tray is moved in the first direction when receiving the external member in the insertion hole while the tray is accommodated in the electronic device.

In a second example, there is provided the tray of the first example, further comprising: a first supporting surface within the tray, wherein the first supporting surface faces a second direction opposite to the first direction, and wherein the first supporting surface supports at least part of a first end of the elastic member; and a second supporting surface within the tray, wherein the second supporting surface faces the first supporting surface and supports a second end of the elastic member opposite to the first end of the elastic member.

In a third example, there is provided the tray of the first or second example, further comprising a seating surface within the tray, wherein the seating surface faces the first direction and is spaced apart from the elastic member along a second direction opposite to the first direction such that a gap exists between the elastic member and the seating surface, wherein the gap is configured to receive a part of the external member when the external member penetrates through the insertion hole into the gap.

In a fourth example, there is provided the tray of any of the first to third examples, wherein a part of the elastic member is exposed in the first direction through the first accommodating hole.

In a fifth example, there is provided the tray of any of the first to fourth examples, further comprising a second accommodating hole connected to the first accommodating hole and having a third cross-sectional area larger than the first cross-sectional area, and wherein the elastic member is accommodated in the second accommodating hole.

In a sixth example, there is provided the tray of any of the first to fifth examples, further comprising a coupling portion disposed on a side surface of the tray facing a direction perpendicular to the first direction, wherein the coupling portion is configured to contact a deformable hooking portion of an interface socket of the electronic device by having a shape corresponding to the hooking portion.

In a seventh example, there is provided the tray of any of the first to sixth examples, wherein the tray is configured to receive an interface chip such that the interface chip electrically connects to an interface circuit of the electronic device when the tray is accommodated in the electronic device.

In an eighth example, there is provided the tray of any of the first to seventh examples, wherein the elastic member further comprises: a deformable region surrounding the insertion hole; and a sealing region connected to the deformable region, wherein the sealing region is configured to contact an inner surface of a through-hole in the housing of the electronic device, when the tray is inserted in the through-hole.

In a ninth example, there is provided the tray of any of the first to eighth examples, wherein the elastic member further comprises: a first region, wherein a part of the first region is exposed in the first direction through the first accommodating hole; and a second region extending from the first region along the second direction opposite to the first direction and having a rigidity lower than the first region.

In a tenth example, there is provided the tray of any of the first to ninth examples, wherein the elastic member further comprises a curved surface curved with respect to the first direction, wherein the curved surface is exposed in the first direction through the first accommodating hole.

In an eleventh example, there is provided the tray of any of the first to ninth examples, wherein the elastic member further comprises at least one inclined surface inclined with respect to the first direction and surrounding the insertion hole.

In a twelfth example, there is provided the tray of the eleventh example, further comprising an inner surface surrounding an outer surface of the elastic member, wherein the at least one inclined surface comprises: a first inclined surface, wherein the distance between the first inclined surface and the inner surface decreases as the surface extends in the first direction; and a second inclined surface, wherein the distance between the second inclined surface and the inner surface increases as the surface extends in the first direction.

In a thirteenth example, there is provided the tray of any of the first to twelfth examples, wherein the insertion hole comprises a first extending region having the second cross-sectional area; and a second extending region comprising a first end which is connected to the first extending region and has the second cross-sectional area, and a second end having a fourth cross-sectional area larger than the second cross-sectional area, wherein the second end of the second extending region is exposed in the first direction through the first accommodating hole.

In a fourteenth example, there is provided an electronic device comprising a housing, wherein the housing comprises a through-hole configured to accommodate the tray of any of the first to thirteenth examples.

In a fifteenth example, there is provided a system comprising the tray of any of the first to thirteenth examples and an electronic device, the electronic device comprising a housing, wherein the housing comprises a through-hole configured to accommodate the tray.

In a sixteenth example, there is provided the system of the fifteenth example, wherein the housing of the electronic device further comprises: a first surface; a second surface opposite to the first surface; and a side surface connecting the first surface and the second surface; wherein the through-hole penetrates the side surface.

In a seventeenth example, there is provided the system of the fifteenth or sixteenth examples, wherein the electronic device further comprises: a printed circuit board disposed in the housing; and an interface socket disposed on one surface of the printed circuit board and configured to receive the tray when the tray is inserted into the through-hole.

In an eighteenth example, there is provided the system of the seventeenth example, wherein the interface socket comprises a hooking portion configured to secure the tray.

In a nineteenth example, there is provided the system of the eighteenth example, comprising the tray of the sixth example, wherein the hooking portion of the interface socket is deformable by the coupling portion of the tray.

In a twentieth example, there is provided the system of any of the fifteenth to nineteenth examples, comprising the tray of the seventh example, wherein the electronic device further comprises: a printed circuit board disposed in the housing; and an interface circuit disposed on one surface of the printed circuit board and configured to electrically connect to the interface chip accommodated in the tray when the tray is accommodated in the electronic device.

In a twenty-first example, there is provided the electronic device of the fourteenth example or the system of any of the fifteenth to twentieth examples, wherein the electronic device does not include a mechanism for releasing a coupling or creating a separation between the tray and the electronic device.

In a twenty-second example, there is provided an electronic device comprising: a housing including a through-hole; and an tray configured to penetrate the through-hole such that at least a part of the tray is disposed in the housing; wherein the tray includes: a first accommodating hole penetrating an outer surface of the tray, wherein the outer surface is exposed to outside of the housing, and wherein the first accommodating hole is configured for insertion of an external member and has a first cross-sectional area; and an elastic member deformable by the external member and including an insertion hole having a second cross-sectional area smaller than the first cross-sectional area, and wherein the tray is movable to the outside of the housing by a movement of the external member in contact with the elastic member when the external member is inserted through the first accommodating hole into the insertion hole.

In a twenty-third example, there is provided the electronic device of the twenty-second example, wherein the tray is configured to move outside of the through-hole by moving along a first direction, or configured to be inserted into the through-hole by moving along a second direction opposite to the first direction, wherein the tray further includes: a first supporting surface within the tray facing the second direction and supporting at least part of one end of the elastic member; and a second supporting surface within the tray facing the first supporting surface and supporting the other end of the elastic member opposite to the one end of the elastic member.

In a twenty-fourth example, there is provided the electronic device according to the twenty-second or the twenty-third example, wherein the tray is configured to move outside of the through-hole by moving along a first direction, or configured to be inserted into the through-hole by moving along a second direction opposite to the first direction, wherein the tray further includes a seating surface within the tray spaced apart from the elastic member along the second direction, and wherein a part of the external member is disposed within a gap between the elastic member and the seating surface when the external member is inserted through the insertion hole into the gap.

In a twenty-fifth example, there is provided the electronic device according to any one of the twenty-second to twenty-fourth examples, wherein a part of the elastic member is exposed to outside of the tray through the first accommodating hole.

In a twenty-sixth example, there is provided the electronic device according to any one of the twenty-second to twenty-fifth examples, wherein the tray further includes a second accommodating hole connected to the first accommodating hole and having a third cross-sectional area larger than the first cross-sectional area, and wherein the elastic member fills the second accommodating hole.

In a twenty-seventh example, there is provided the electronic device according to any one of the twenty-second to twenty-sixth examples, wherein the housing further includes: a first surface; a second surface opposite to the first surface; and a side surface connecting the first surface and the second surface; and wherein the through-hole penetrates the side surface.

In a twenty-eighth example, there is provided the electronic device according to any one of the twenty-second to twenty-seventh examples, further including: a printed circuit board disposed in the housing; and an interface socket disposed on one surface of the printed circuit board and configured to cover the tray when the tray is inserted into the through-hole.

In a twenty-ninth example, there is provided the electronic device of the twenty-eighth example, wherein the interface socket includes hooking portion deformable by the tray, and wherein the tray further includes a coupling portion disposed on a side surface of the tray facing a direction perpendicular to a moving direction of the tray, wherein the coupling portion is configured to contact with the hooking portion by having a shape corresponding to the hooking portion.

In a thirtieth example, there is provided the electronic device according to any one of the twenty-second to twenty-ninth examples, further including: a printed circuit board disposed in the housing; and an interface chip coupled to the tray and configured to face the printed circuit board while the tray is inserted in the through-hole; and wherein the printed circuit board includes an interface circuit disposed on one surface of the printed circuit board and configured to electrically connect to the interface chip while the tray is inserted in the through-hole.

In a thirty-first example, there is provided the electronic device according to any one of the twenty-second to thirtieth examples, wherein the elastic member further includes: a deformable region surrounding the insertion hole; and a sealing region connected to the deformable region and in contact with an inner surface of the through-hole while the tray is inserted in the through-hole.

In a thirty-second example, there is provided the electronic device according to any one of the twenty-second to thirty-first examples, wherein the tray is configured to move outside of the through-hole by moving along a first direction or is configured to be inserted into the through-hole by moving along a second direction opposite to the first direction, and wherein the elastic member further includes: a first region, a part of which is exposed to outside of the tray through the first accommodating hole; and a second region extending from the first region along the second direction and having a rigidity lower than the first region.

In a thirty-third example, there is provided the electronic device according to any one of the twenty-second to thirty-second examples, wherein the elastic member further includes a curved surface curved with respect to a moving direction of the tray and exposed to outside of the tray through the first accommodating hole.

In a thirty-fourth example, there is provided the electronic device according to any one of the twenty-second to thirty-second examples, wherein the elastic member further includes at least one inclined surface inclined with respect to a moving direction of the tray and surrounding the insertion hole.

In a thirty-fifth example, there is provided the electronic device according to the thirty-fourth example, wherein the tray further includes an inner surface surrounding an outer surface of the elastic member and wherein the at least one inclined surface includes: a first inclined surface, wherein the distance between the first inclined surface and the inner surface decreases as the surface extends in the first direction; and a second inclined surface, wherein the distance between the second inclined surface and the inner surface increases as the surface extends in the first direction.

In a thirty-sixth example, there is provided the electronic device according to any one of the twenty-second to thirty-fifth examples, wherein the insertion hole includes: a first extending region having the second cross-sectional area; and a second extending region one end of which is connected to the first extending region and has the second cross-sectional area, wherein the other end of the second extending region has a fourth cross-sectional area larger than the second cross-sectional area, and wherein the other end of the second extending region is exposed to outside of the tray through the first accommodating hole.

In a thirty-seventh example, there is provided an electronic device comprising: a housing including a through-hole; a printed circuit board disposed in the housing; and an tray moving outside of the through-hole by moving along a first direction or disposed on the printed circuit board by moving along a second direction to be inserted into the through-hole, wherein the tray includes: an outer surface exposed to outside of the housing while the tray is inserted into the through-hole; a first supporting surface within the tray facing the second direction; a first accommodating hole for insertion of an external member, wherein the first accommodating hole extends from the outer surface to the first supporting surface, and has a first cross-sectional area; an elastic member including an insertion hole having a second cross-sectional area smaller than the first cross-sectional area, wherein at least part of one end of the elastic member is supported by the first supporting surface; and a second supporting surface within the tray facing the first supporting surface and supporting at least part of the other end of the elastic member opposite to the one end of the elastic member; and wherein the tray is movable to the outside of the through-hole by a movement of the external member in contact with the elastic member in the first direction when the external member is inserted through the first accommodating hole into the insertion hole.

In a thirty-eighth example, there is provided the electronic device of the thirty-seventh example, wherein the tray further includes a seating surface within the tray spaced apart from the elastic member along the second direction and facing the second supporting surface, wherein a part of the external member is disposed within a gap between the elastic member and the seating surface when the external member is inserted through the insertion hole into the gap.

In a thirty-ninth example, there is provided the electronic device according to any one of the thirty-seventh to thirty-eighth examples, wherein the at least part of the one end of the elastic member is exposed to the outside of the tray through the first accommodating hole.

In a fortieth example, there is provided the electronic device according to any one of claims the thirty-seventh to thirty-ninth examples, further including an interface socket configured to cover the tray when the tray is inserted into the through-hole, wherein the interface socket is disposed on one surface of the printed circuit board.

In a forty-first example, there is provided the electronic device according to any one of the thirty-seventh to fortieth examples, further including an interface chip coupled to the tray and configured to face the printed circuit board while the tray is inserted in the through-hole; and wherein the printed circuit board includes an interface circuit disposed on one surface of the printed circuit board and configured to electrically connect to the interface chip while the tray is inserted in the through-hole.

## Claims

1. An electronic device (101; 200; 400) comprising:
a housing (410) including an opening (411); and
a tray (430) configured to be inserted into the housing (410) through the opening (411);
wherein the tray (430) includes:
a first hole (433) exposed to outside of the housing (410); and
an elastic member (500) disposed in the housing while the tray (430) is inserted into the housing and including a second hole (510) aligned with the first hole (433);
wherein the elastic member (500) is configured to:
at least partially hold an external member(t1) being inserted into the second hole (510) through the first hole (433) so as to at least partially eject the tray (430) from inside of the housing (410) to the outside of the housing (410) according to the external member(t1) being moved.

2. The electronic device (101; 200; 400) of claim 1,
wherein the cross-sectional area of the second hole (510) is smaller than the cross-sectional area of the external member(t1) before the external member is inserted into, and
wherein the elastic member (500) is configured to at least partially hold the external member(t1) by being deformed to expand the cross-sectional area of the second hole (510) according to the external member(t1) being inserted into the second hole (510).

3. The electronic device (101; 200; 400) according to claim 1 or 2,
wherein the tray further includes:
a head part (430-1) on which the elastic member (500) disposed and including a first hole (433); and
a body part (430-2) coupled to the head part (430-1) and configured to accommodate an interface chip (440).

4. The electronic device (101; 200; 400) according to any one of claims 1 to 3,
wherein the tray (430) is configured to move outside of the opening (411) by moving along a first direction, or configured to be inserted into the opening (411) by moving along a second direction opposite to the first direction,
wherein the tray (430) further includes:
a first supporting surface(430d) within the tray (430) facing the second direction and supporting at least part of one end of the elastic member (500); and
a second supporting surface(430e) within the tray (430) facing the first supporting surface(430d) and supporting the other end of the elastic member (500) opposite to the one end of the elastic member (500).

5. The electronic device (101; 200; 400) according to any one claims 1 to 4,
wherein the tray (430) is configured to move outside of the opening (411) by moving along a first direction, or configured to be inserted into the opening (411) by moving along a second direction opposite to the first direction,
wherein the tray (430) further includes a seating surface within the tray (430) spaced apart from the elastic member (500) along the second direction, and
wherein a part of the external member(t1) is disposed within a gap between the elastic member (500) and the seating surface when the external member (t1) is inserted through the second hole (510) into the gap.

6. The electronic device (101; 200; 400) according to any one of claims 1 to 5,
wherein a part of the elastic member (500) is exposed to outside of the tray (430) through the first hole (433).

7. The electronic device (101; 200; 400) according to any one of claims 1 to 6,
wherein the tray (430) further includes a third hole (434) connected to the first hole (433) and having a cross-sectional area larger than the cross-sectional area of the first hole (433), and
wherein the elastic member (500) fills the third hole (433).

8. The electronic device (101; 200; 400) according to any one of claims 1 to 7,
wherein the housing (410) further includes:
a first surface(410a);
a second surface(410b) opposite to the first surface(410a); and
a side surface(410c) connecting the first surface(410a) and the second surface(410b); and
wherein the opening (411) penetrates the side surface(410c).

9. The electronic device (101; 200; 400) according to any one of claims 1 to 8, further including:
a printed circuit board (450) disposed in the housing (410); and
an interface socket disposed on one surface of the printed circuit board (450) and configured to cover the tray (430) when the tray (430) is inserted into the opening (411).

10. The electronic device (101; 200; 400) of claim 9,
wherein the interface socket includes hooking portion deformable by the tray (430), and
wherein the tray (430) further includes a coupling portion disposed on a side surface(410c) of the tray (430) facing a direction perpendicular to a moving direction of the tray (430), wherein the coupling portion is configured to contact with the hooking portion by having a shape corresponding to the hooking portion.

11. The electronic device (101; 200; 400) according to any one of claims 1 to 10, further including:
a printed circuit board (450) disposed in the housing (410); and
an interface chip coupled to the tray (430) and configured to face the printed circuit board (450) while the tray (430) is inserted in the opening (411); and
wherein the printed circuit board (450) includes an interface circuit disposed on one surface of the printed circuit board (450) and configured to electrically connect to the interface chip while the tray (430) is inserted in the opening (411).

12. The electronic device (101; 200; 400) according to any one of claims 1 to 11,
wherein the elastic member (500) further includes:
a deformable region surrounding the second hole (510); and
a sealing region connected to the deformable region and in contact with an inner surface of the opening (411) while the tray (430) is inserted in the opening (411).

13. The electronic device (101; 200; 400) according to any one of claims 1 to 12,
wherein the tray (430) is configured to move outside of the opening (411) by moving along a first direction or is configured to be inserted into the opening (411) by moving along a second direction opposite to the first direction, and
wherein the elastic member (500) further includes:
a first region, a part of which is exposed to outside of the tray (430) through the first hole (433); and
a second region extending from the first region along the second direction and having a rigidity lower than the first region.

14. The electronic device (101; 200; 400) according to any one of claims 1 to 13,
wherein the elastic member (500) further includes at least one inclined surface inclined with respect to a first direction which is the moving direction of the tray (430) and surrounding the second hole (510),
wherein the tray (430) further includes an inner surface surrounding an outer surface of the elastic member (500) and
wherein the at least one inclined surface includes:
a first inclined surface, wherein the distance between the first inclined surface and the inner surface decreases as the surface extends in the first direction; and
a second inclined surface, wherein the distance between the second inclined surface and the inner surface increases as the surface extends in the first direction.

15. The electronic device (101; 200; 400) according to any one of claims 1 to 14,
wherein the second hole (510) includes:
a first extending region; and
a second extending region one end of which is connected to the first extending region and has a cross-sectional area same with the cross-sectional area of the first extending region, wherein the other end of the second extending region has a cross-sectional area larger than the cross-sectional area of the first extending region, and wherein the other end of the second extending region is exposed to outside of the tray(430) through the first hole(433).
